# EUROPEAN PATENT APPLICATION

(11) **EP 4 436 332 A1**
(43) Date of publication of application: **25.09.2024**
(21) Application number: 24162357.8
(22) Date of filing: 08.03.2024
(51) Int. Cl.: H10B 43/27, H10B 43/10, H10B 43/40, H10B 43/50

(54) **NON-VOLATILE MEMORY DEVICE AND MEMORY SYSTEM INCLUDING THE SAME**

(30) Priority: 24.03.2023 KR 20230039157; 02.05.2023 KR 20230057367
(71) Applicant: Samsung Electronics Co., Ltd., Suwon-si, Gyeonggi-do 16677 (KR)
(72) Inventor: PARK, Kyeonghoon, 16677 Suwon-si, Gyeonggi-do (KR); BAEK, Jaebok, 16677 Suwon-si, Gyeonggi-do (KR); YUN, Janggn, 16677 Suwon-si, Gyeonggi-do (KR); HAN, Jeehoon, 16677 Suwon-si, Gyeonggi-do (KR)
(74) Representative: Kuhnen & Wacker Patent- und Rechtsanwaltsbüro PartG mbB

(57) **Abstract**

A non-volatile memory device includes a peripheral circuit structure and a cell array structure on the peripheral circuit structure, where the cell array structure includes a base insulation layer, a common source line layer on the base insulation layer, a buffer insulation layer on the common source line layer, and a cell stack on the buffer insulation layer, where the cell stack includes a plurality of gate electrodes and a plurality of insulation layers, where the plurality of gate electrodes have a staircase shape, a plurality of gate contact plugs that extend into the cell stack, and a plurality of protection structures between the plurality of gate contact plugs and the base insulation layer.

## Description

### TECHNICAL FIELD

The present disclosure relates to a non-volatile memory device and a memory system including the same, and more particularly, to a three-dimensional non-volatile memory device and a memory system including the same.

### BACKGROUND

Consumers demand non-volatile memory devices having high performance, a small size, and a low price. Therefore, to implement non-volatile memory devices where the degree of integration is high, three-dimensional non-volatile memory devices where a plurality of memory cells are arranged in the vertical direction have been proposed.

### SUMMARY

The present disclosure provides a non-volatile memory device having operation reliability and a memory system including the same.

According to an aspect of the present disclosure, a non-volatile memory device includes a peripheral circuit structure including a peripheral circuit and a first insulation structure on the peripheral circuit; and a cell array structure on the peripheral circuit structure, where the cell array structure includes: a base insulation layer; a common source line layer on the base insulation layer; a buffer insulation layer on the common source line layer; a cell stack on the buffer insulation layer, where the cell stack includes a plurality of gate electrodes and a plurality of insulation layers, and where the plurality of gate electrodes have a nonlinear shape; a plurality of cell channel structures that extend into the cell stack and the buffer insulation layer and that are connected to the common source line layer; a plurality of gate contact plugs that extend into the cell stack, where each gate contact plug of the plurality of gate contact plugs is connected to one corresponding gate electrode of the plurality of gate electrodes; a plurality of protection structures between the plurality of gate contact plugs and the base insulation layer; a plurality of cut insulation layers that extend into the base insulation layer, where the plurality of cut insulation layers are between the common source line layer and the plurality of protection structures, and where the plurality of cut insulation layers at least partially surround the plurality of gate contact plugs; and a second insulation structure on the cell stack and that is connected to the first insulation structure.

According to another aspect of the present disclosure, a non-volatile memory device includes a peripheral circuit structure comprising a peripheral circuit and a first insulation structure on the peripheral circuit; and a cell array structure on the peripheral circuit structure, where the cell array structure includes: a base insulation layer; a common source line layer on the base insulation layer; a buffer insulation layer on the common source line layer; and a cell stack on the buffer insulation layer, where the cell stack includes a plurality of gate electrodes and a plurality of insulation layers, and where the plurality of gate electrodes have a nonlinear shape; a plurality of cell channel structures that extend into the cell stack and the buffer insulation layer and that are connected to the common source line layer; a plurality of gate contact plugs that extend into the cell stack, where each gate contact plug of the plurality of gate contact plugs is connected to one corresponding gate electrode of the plurality of gate electrodes; a plurality of dummy channel structures that extend into the cell stack and are connected to the common source line layer, where each dummy channel structure of the plurality of dummy channel structures at least partially surrounds one corresponding gate contact plug of the plurality of gate contact plugs; a charge insulation layer on the common source line layer and the cell stack; a plurality of first protection structures, where each first protection structure of the plurality of first protection structures is between one corresponding gate contact plug of the plurality of gate contact plugs and the base insulation layer; a plurality of first cut insulation layers that extend into at least a portion of the base insulation layer, where each first cut insulation layer of the plurality of first cut insulation layers is between the common source line layer and one corresponding first protection structure of the plurality of first protection structures to at least partially surround one corresponding gate contact plug of the plurality of gate contact plugs; a plurality of through contact plugs that extend into the charge insulation layer and are connected to the peripheral circuit; a plurality of peripheral connection pads that are connected to the plurality of through contact plugs and within the base insulation layer; a plurality of second protection structures, where each second protection structure of the plurality of second protection structures is between one corresponding peripheral connection pad of the plurality of peripheral connection pads and the base insulation layer; a second cut insulation layer that extends into at least a portion of the base insulation layer, where the second cut insulation layer is between the common source line layer and the plurality of second protection structures to at least partially surround at least one of the plurality of through contact plugs; and a second insulation structure that is on the cell stack and the charge insulation layer and connected to the first insulation structure.

According to another aspect of the present disclosure, a memory system includes a non-volatile memory device comprising a peripheral circuit structure, where the peripheral circuit structure includes a peripheral circuit, a first insulation structure on the peripheral circuit, and a cell array structure on the peripheral circuit structure; and a memory controller electrically connected with the non-volatile memory device, where the cell array structure includes: a base insulation layer; a common source line layer on the base insulation layer; a buffer insulation layer on the common source line layer; a cell stack on the buffer insulation layer, where the cell stack includes a plurality of gate electrodes and a plurality of insulation layers, and where the plurality of gate electrodes have a nonlinear shape; a plurality of cell channel structures that extend into the cell stack and the buffer insulation layer and that are connected to the common source line layer; a plurality of gate contact plugs that extend into the cell stack, where each gate contact plug of the plurality of gate contact plugs is connected to one corresponding gate electrode of the plurality of gate electrodes; a plurality of protection structures between the plurality of gate contact plugs and the base insulation layer; a plurality of cut insulation layers that extend into the base insulation layer, where the plurality of cut insulation layers are between the common source line layer and the plurality of protection structures, and where the plurality of cut insulation layers at least partially surround the plurality of gate contact plugs; and a second insulation structure on the cell stack and that is connected to the first insulation structure.

### BRIEF DESCRIPTION OF THE DRAWINGS

Embodiments will be more clearly understood from the following detailed description taken in conjunction with the accompanying drawings in which:
FIG. 1 is a block diagram of a non-volatile memory device according to embodiments of the present disclosure;
FIG. 2 is a schematic perspective view of a non-volatile memory device according to embodiments of the present disclosure;
FIG. 3 is an equivalent circuit diagram of a memory cell array of a non-volatile memory device according to embodiments of the present disclosure;
FIG. 4 is a schematic layout view of a non-volatile memory device according to embodiments of the present disclosure;
FIG. 5 is a schematic plan view of a non-volatile memory device according to embodiments of the present disclosure;
FIGS. 6A, 6B, 6C, and 6D are cross-sectional views of a non-volatile memory device according to embodiments of the present disclosure;
FIGS. 7A, 7B, 7C, 7D and 7E are enlarged plan views of some regions of a non-volatile memory device according to embodiments of the present disclosure;
FIGS. 8A and 8B are enlarged plan views of some regions of a non-volatile memory device according to embodiments of the present disclosure;
FIGS. 9A, 9B, 9C, 9D, 9E, and 9F are cross-sectional views illustrating a method of manufacturing a non-volatile memory device, according to embodiments of the present disclosure;
FIG. 10 is a cross-sectional view of a non-volatile memory device having a C2C structure, according to embodiments of the present disclosure;
FIG. 11 is a cross-sectional view of a non-volatile memory device having a C2C structure, according to embodiments of the present disclosure;
FIG. 12 is a diagram schematically illustrating a memory system including a non-volatile memory device, according to embodiments of the present disclosure;
FIG. 13 is a perspective view schematically illustrating a memory system including a non-volatile memory device, according to embodiments of the present disclosure; and
FIG. 14 is a cross-sectional view schematically illustrating a semiconductor package according to embodiments of the present disclosure.

### DETAILED DESCRIPTION OF THE EMBODIMENTS

To clarify the present disclosure, parts that are not connected with the description will be omitted, and the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the phrase "at least one of A, B, and C" refers to a logical (A OR B OR C) using a non-exclusive logical OR, and should not be construed to mean "at least one of A, at least one ofB and at least one of C." As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof. The term "and/or" includes any and all combinations of one or more of the associated listed items. The term "connected" may be used herein to refer to a physical and/or electrical connection and may refer to a direct or indirect physical and/or electrical connection.

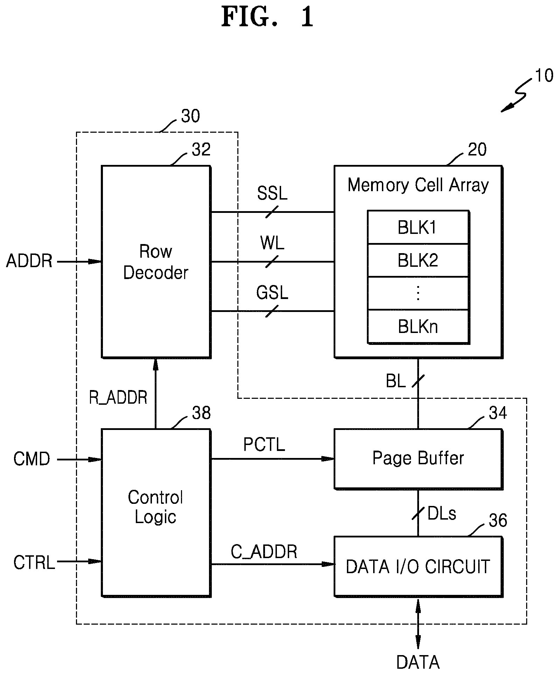

FIG. 1 is a block diagram of a non-volatile memory device 10 according to embodiments of the present disclosure.

Referring to FIG. 1, the non-volatile memory device 10 may include a memory cell array 20 and a peripheral circuit 30. The memory cell array 20 may include a plurality of memory cell blocks BLK1, BLK2, ..., and BLKn. Each of the plurality of memory cell blocks BLK1, BLK2, ..., and BLKn may include a plurality of memory cells. The plurality of memory cell blocks BLK1, BLK2, ..., and BLKn may be connected to the peripheral circuit 30 through a bit line BL, a word line WL, a string selection line SSL, and a ground selection line GSL.

The peripheral circuit 30 may include a row decoder 32, a page buffer 34, a data input/output (I/O) circuit 36, and a control logic 38. In some embodiments, the peripheral circuit 30 may include an I/O interface, a column logic, a voltage generator, a pre-decoder, a temperature sensor, a command decoder, an address decoder, and an amplifier circuit.

The memory cell array 20 may be connected to the page buffer 34 through the bit line BL and may be connected to the row decoder 32 through the word line WL, the string selection line SSL, and the ground selection line GSL. In the memory cell array 20, each of the plurality of memory cells included in each of the plurality of memory cell blocks BLK1, BLK2, ..., and BLKn may be a flash memory cell. The memory cell array 20 may include a three-dimensional (3D) memory cell array. The 3D memory cell array may include a plurality of NAND strings extending in the vertical direction, and each of the plurality of NAND strings may include a plurality of memory cells which are respectively connected to a plurality of word lines WL vertically stacked on a substrate.

The peripheral circuit 30 may receive an address ADDR, a command CMD, and a control signal CTRL that is external of the non-volatile memory device 10 and may transmit or receive data DATA to or from a device that is external of the non-volatile memory device 10.

The row decoder 32 may select at least one memory cell block from among the plurality of memory cell blocks BLK1, BLK2, ..., and BLKn in response to the address ADDR and may select a word line WL, a string selection line SSL, and a ground selection line GSL of the selected memory cell block. The row decoder 32 may transfer a voltage, which is used for performing a memory operation, to the word line WL of the selected memory cell block.

The page buffer 34 may be connected to the memory cell array 20 through the bit line BL. The page buffer 34 may operate as a write driver in a program operation to apply a voltage based on data DATA, which is to be stored in the memory cell array 20, to the bit line BL and may operate as a sense amplifier in a read operation to sense data DATA stored in the memory cell array 20. The page buffer 34 may operate based on the control signal CTRL provided from the control logic 38.

The data I/O circuit 36 may be connected to the page buffer 34 through data lines DLs. The data I/O circuit 36 may receive data DATA from a memory controller (not shown) in a program operation and may provide program data DATA to the page buffer 34 based on a column address C_ADDR provided from the control logic 38. In a read operation, the data I/O circuit 36 may provide the memory controller with read data DATA stored in the page buffer 34 based on the column address C_ADDR provided from the control logic 38.

The data I/O circuit 36 may transfer an input address or command to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide a row address R_ADDR to the row decoder 32 and may provide the column address C_ADDR to the data I/O circuit 36. The control logic 38 may generate various internal control signals used in the non-volatile memory device 10 in response to the control signal CTRL. For example, the control logic 38 may adjust a voltage level provided to the word line WL and the bit line BL when performing a memory operation such as a program operation or an erase operation.

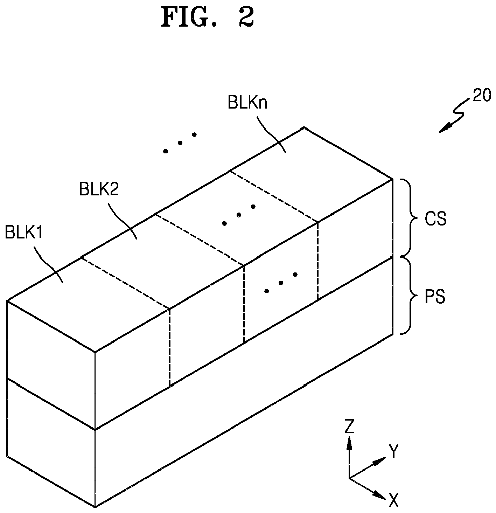

FIG. 2 is a schematic perspective view of a non-volatile memory device 10 according to embodiments of the present disclosure.

Referring to FIG. 2, the non-volatile memory device 10 may include a cell array structure CS and a peripheral circuit structure PS, which overlap each other in the vertical direction (Z direction). The cell array structure CS may include the memory cell array 20 described above with reference to FIG. 1. The peripheral circuit structure PS may include the peripheral circuit 30 described above with reference to FIG. 1.

The cell array structure CS may include a plurality of memory cell blocks BLK1, BLK2, ..., and BLKn. Each of the plurality of memory cell blocks BLK1, BLK2, ..., and BLKn may include a plurality of memory cells, which are three-dimensionally arranged.

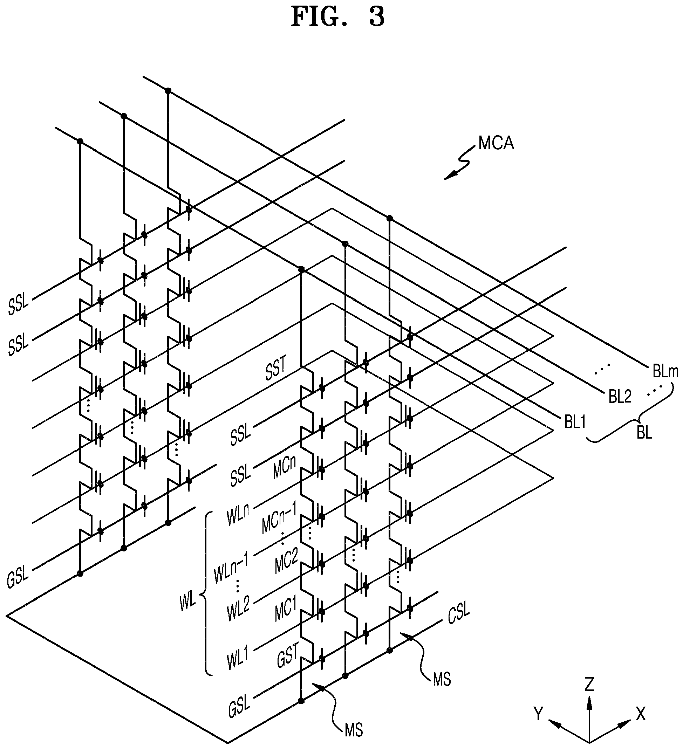

FIG. 3 is an equivalent circuit diagram of a memory cell array MCA of a non-volatile memory device according to embodiments of the present disclosure.

Referring to FIG. 3, the memory cell array MCA may include a plurality of memory cell strings MS. Each of the plurality of memory cell strings MS may extend in the vertical direction (Z direction). The memory cell array MCA may include a plurality of word lines WL1, WL2, ..., WLn-1, and WLn (WL), a plurality of bit lines BL1, BL2, ..., and BLm (BL), at least one string selection line SSL, at least one ground selection line GSL, and a common source line CSL. Each of the plurality of word lines WL1, WL2, ..., WLn-1, and WLn (WL) may extend in a first horizontal direction (X direction), and each of the plurality of bit lines BL1, BL2, ..., and BLm (BL) may extend in a second horizontal direction (Y direction) perpendicular to the first horizontal direction (the X direction). Each of the at least one string selection line SSL and the at least one ground selection line GSL may extend in the same direction (for example, the first horizontal direction (the X direction)) as the plurality of word lines WL1, WL2, ..., WLn-1, and WLn (WL). The plurality of memory cell strings MS may be formed between the plurality of bit lines BL1, BL2, ..., and BLm (BL) and the common source line CSL. In FIG. 3, a case where each of the plurality of memory cell strings MS includes two string selection lines SSL is illustrated, but the present disclosure is not limited thereto. For example, each of the plurality of memory cell strings MS may include one string selection line SSL.

Each of the plurality of memory cell strings MS may include a string selection transistor SST, a ground selection transistor GST, and a plurality of memory cell transistors MC1, MC2, ..., MCn-1, and MCn. A drain region of the string selection transistor SST may be connected to the plurality of bit lines BL1, BL2, ..., and BLm (BL), and a source region of the ground selection transistor GST may be connected to the common source line CSL. The common source line CSL may be a region which may be connected to a source region of each of a plurality of ground selection transistors GST.

The string selection transistor SST may be connected to the string selection line SSL, and the ground selection transistor GST may be connected to the ground selection line GSL. The plurality of memory cell transistors MC1, MC2, ..., MCn-1, and MCn may be respectively connected to the plurality of word lines WL1, WL2, ..., WLn-1, and WLn (WL).

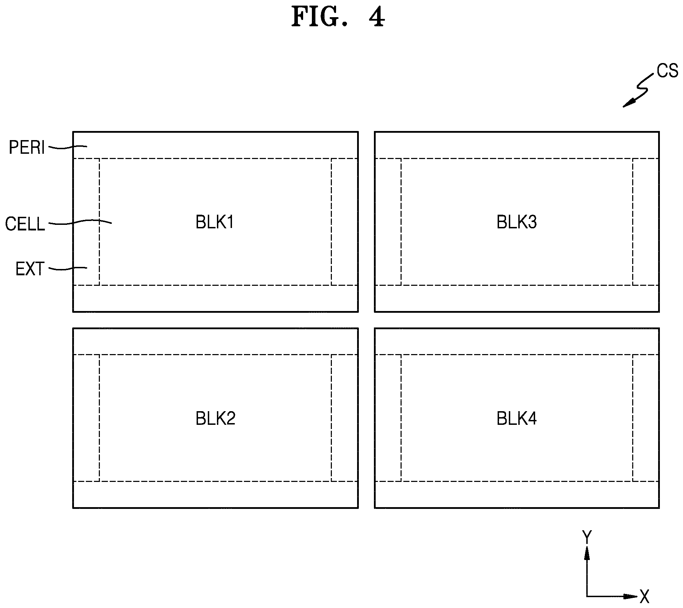

FIG. 4 is a schematic layout view of a cell array structure CS included in a non-volatile memory device according to embodiments of the present disclosure.

Referring to FIG. 4, the cell array structure CS may include a plurality of memory cell blocks BLK1 to BLK4. The plurality of memory cell blocks BLK1 to BLK4 may be arranged to form a row and a column in a first horizontal direction (X direction) and a second horizontal direction (Y direction). The first horizontal direction (the X direction) may be an extension direction of each of the plurality of word lines WL1, WL2, ..., WLn-1, and WLn (WL), and the second horizontal direction (the Y direction) may be an extension direction of each of the plurality of bit lines BL1, BL2, ..., and BLm (BL) illustrated in FIG. 3. Each of the plurality of memory cell blocks BLK1 to BLK4 may include a plurality of memory cells.

Each of the plurality of memory cell blocks BLK1 to BLK4 may include a cell region CELL and a connection region EXT. In some embodiments, each of the plurality of memory cell blocks BLK1 to BLK4 may include one cell region CELL and a pair of connection regions EXT on both sides of the one cell region CELL. The pair of connection regions EXT may extend in the second horizontal direction (the Y direction) on both sides of the one cell region CELL in the first horizontal direction (the X direction). In some other embodiments, each of the plurality of memory cell blocks BLK1 to BLK4 may include one cell region CELL and one connection region EXT on one side of the one cell region CELL. In some other embodiments, each of the plurality of memory cell blocks BLK1 to BLK4 may include one cell region CELL and two pairs of connection regions EXT on both sides of the one cell region CELL in the first horizontal direction (the X direction) and both sides of the one cell region CELL in the second horizontal direction (the Y direction).

In some embodiments, each of the plurality of memory cell blocks BLK1 to BLK4 may further include a cell peripheral circuit region PERI. The cell peripheral circuit region PERI may be on one or both sides of the cell region CELL in the second horizontal direction (the Y direction). For example, elements for connecting the cell region CELL and/or the connection region EXT with the peripheral circuit structure PS described above with reference to FIG. 2 may be part of the cell peripheral circuit region PERI. Alternatively, for example, at least a portion of the peripheral circuit 30 described above with reference to FIG. 1 may be part of the cell peripheral circuit region PERI.

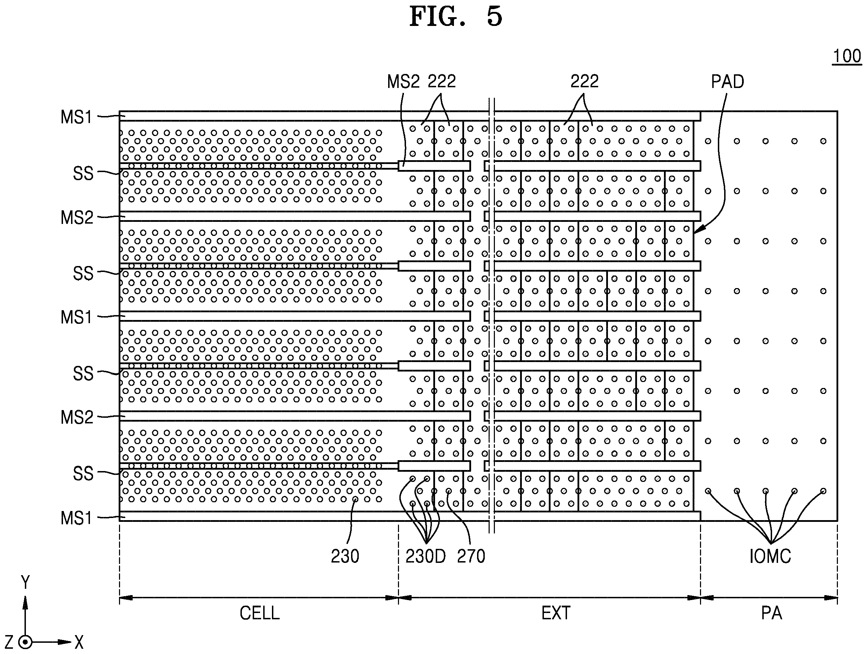

FIG. 5 is a schematic plan view of a non-volatile memory device 100 according to embodiments of the present disclosure.

Referring to FIG. 5, the non-volatile memory device 100 may include a cell region CELL, a connection region EXT, and a peripheral connection region PA. FIG. 5 illustrates a schematic plan view of a cell array structure (CS of FIG. 2) included in the non-volatile memory device 100. The connection region EXT may be on at least one end of the cell region CELL in at least one direction (for example, a first horizontal direction (X direction)).

A plurality of gate electrodes 222 may be spaced apart from one another in the vertical direction (Z direction). The plurality of gate electrodes 222 may be spaced apart from one another in the vertical direction (the Z direction) in the cell region CELL, and the plurality of gate electrodes 222 may extend by different lengths in the first horizontal direction (the X direction) in the connection region EXT. A plurality of cell channel structures 230 extending through the stacked plurality of gate electrodes 222 may be part of the cell region CELL. A plurality of gate contact plugs 270 electrically connecting the plurality of gate electrodes 222 with a peripheral circuit structure (PS of FIG. 2) may be part of the connection region EXT. A plurality of through contact plugs IOMC electrically connecting the peripheral circuit structure PS with an external device may be part of the peripheral connection region PA.

The plurality of gate electrodes 222 may be spaced apart from one another in the vertical direction (the Z direction) in the cell region CELL and may extend by different lengths from the cell region CELL to the connection region EXT, and thus, may be a stepped structure having a nonlinear shape (e.g., a staircase shape). The plurality of gate electrodes 222 may have a stepped structure between gate electrodes 222 adjacent to one another in the vertical direction (the Z direction) in the first horizontal direction (the X direction) but are not limited thereto. For example, the plurality of gate electrodes 222 may be arranged to have a stepped structure in a second horizontal direction (Y direction) and may be arranged to have a stepped structure in the first horizontal direction (the X direction) and the second horizontal direction (the Y direction).

As a result of the stepped structures, each of the plurality of gate electrodes 222 may include portions which extend further than the other gate electrode 222 adjacent thereto in the vertical direction (the Z direction), and each of the portions may be referred to as a pad portion PAD. In each of the plurality of gate electrodes 222, the pad portion PAD may include a portion in the first horizontal direction (the X direction). In some embodiments, each of the plurality of gate electrodes 222 may have an increased thickness in a portion including at least pad portion PAD in the connection region EXT.

A first separation region MS1 and a second separation region MS2 may extend through the stacked plurality of gate electrodes 222. The first separation region MS1 and the second separation region MS2 may extend in parallel in the first horizontal direction (the X direction). The first separation region MS1 may continuously extend in the first horizontal direction (the X direction), and the second separation region MS2 may be periodically extend between a pair of first separation regions MS1 or extend in only some regions, but the present disclosure is not limited thereto. The plurality of gate electrodes 222 may be spaced apart from one another in the second horizontal direction (the Y direction) by the first separation region MS1 extending in the first horizontal direction (the X direction). Gate electrodes 222 between a pair of first separation regions MS1 may correspond to one memory cell block (each of BLK1, BLK2, ..., and BLKn of FIG. 1), but a range of each of the memory cell blocks BLK1, BLK2, ..., and BLKn is not limited thereto.

An upper separation region SS may extend in the first horizontal direction (the X direction) between the cell region CELL, the first separation region MS1, and the second separation region MS2. The upper separation region SS, as illustrated in FIG. 5, may separate some of the plurality of gate electrodes 222 from one another in the second horizontal direction (the Y direction). Gate electrodes 222 separated by the upper separation region SS may correspond to different string selection lines (SSL of FIG. 1).

The plurality of cell channel structures 230 may correspond to one memory cell string (MS of FIG. 3) and may be spaced apart from one another to form a row and a column in the cell region CELL. The plurality of cell channel structures 230 may be arranged to form a lattice pattern, or may be arranged in a zigzag shape in one direction.

The plurality of gate contact plugs 270 may extend through the gate electrodes 222 in the vertical direction (the Z direction) in the connection region EXT and may be electrically connected with one pad portion PAD among the plurality of gate electrodes 222.

The plurality of dummy channel structures 230D may extend through the gate electrodes 222 in the vertical direction (the Z direction) in the connection region EXT and may be adjacent to the plurality of gate contact plugs 270. The plurality of dummy channel structures 230D may be spaced apart from one another to form a row and a column in the connection region EXT. In FIG. 5, the plurality of dummy channel structures 230D are illustrated as being on only the connection region EXT but are not limited thereto. In some embodiments, some of the plurality of dummy channel structures 230D may be on a portion of a cell region CELL adjacent to the connection region EXT. Each of the plurality of dummy channel structures 230D may include the same structure and material as those of the cell channel structure 230 but is not limited thereto. For example, the plurality of dummy channel structures 230D may include an insulating material.

FIG. 5 illustrates six dummy channel structures 230D that surround one gate contact plug 270 in a hexagonal structure, but the present disclosure is not limited thereto. For example, an arrangement between the plurality of gate contact plugs 270 and the plurality of dummy channel structures 230D, such as four dummy channel structures 230D surrounding one gate contact plug 270 in a tetragonal structure, may vary in other embodiments.

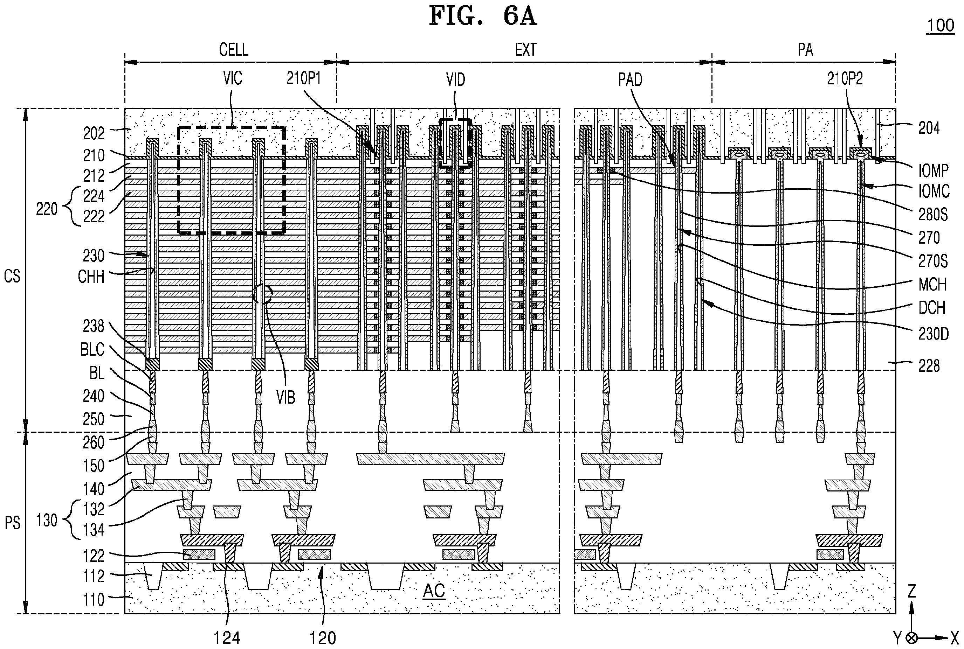

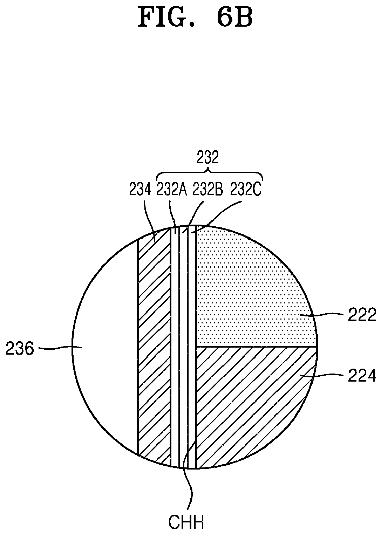

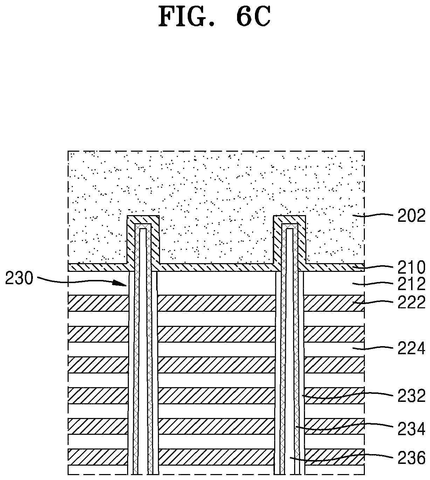

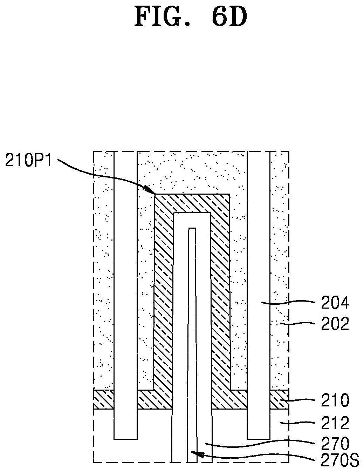

FIGS. 6A to 6D are cross-sectional views of a non-volatile memory device 100 according to embodiments of the present disclosure. In detail, FIGS. 6B, 6C, and 6D are enlarged cross-sectional views of a region VIB, a region VIC, and a region VID of FIG. 6A.

Referring to FIGS. 6A to 6D, the non-volatile memory device 100 may include a peripheral circuit structure PS and a cell array structure CS, which are attached to/on each other in the vertical direction (Z direction). The peripheral circuit structure PS and the cell array structure CS may be referred to as a first structure and a second structure, respectively. The peripheral circuit structure PS may include the peripheral circuit 30 described above with reference to FIG. 1, and the cell array structure CS may include the memory cell array 20 described above with reference to FIG. 1. The cell array structure CS may include memory cells that are three-dimensionally arranged. The cell array structure CS may include a cell region CELL, a connection region EXT, and a peripheral connection region PA.

The cell array structure CS may further include the cell peripheral circuit region PERI illustrated in FIG. 4. Elements for electrically connecting the peripheral circuit structure PS to the connection region EXT and/or the cell region CELL, including an element for electrically connecting a common source line layer 210 to the peripheral circuit structure PS, and elements for electrically connecting the peripheral circuit structure PS to an I/O pad connected to an external device may be part of the cell peripheral circuit region PERI. In some embodiments, the peripheral connection region PA may be a portion of the cell peripheral circuit region PERI illustrated in FIG. 4.

The peripheral circuit structure PS may include a substrate 110 and a peripheral circuit 120 on the substrate 110, a first interconnect structure 130 electrically connected to the peripheral circuit 120, a first bonding pad 150 electrically connected to the first interconnect structure 130, and a first insulation structure 140 on the substrate 110 and the peripheral circuit 120.

The substrate 110 may include, for example, semiconductor materials such as Group IV semiconductor materials, Group III-V semiconductor materials or Group II-VI semiconductor materials, and Group II-VI oxide semiconductor materials. The Group IV semiconductor materials may include, for example, silicon (Si), germanium (Ge), or silicon germanium (SiGe). The Group III-V semiconductor materials may include, for example, gallium arsenide (GaAs), indium phosphide (InP), gallium phosphide (GaP), indium arsenide (InAs), indium antimony (InSb), or indium gallium arsenide (InGaAs). The Group II-IV semiconductor materials may include, for example, zinc tellurium (ZnTe) or cadmium sulfur (CdS). The substrate 110 may be a bulk wafer or an epitaxial layer. In other embodiments, the substrate 110 may include a silicon-on-insulator (SOI) substrate or a germanium-on-insulator (GOI) substrate. An active region AC may be defined by a device isolation layer 112 in the substrate 110, and a plurality of peripheral circuits 120 may be provided in the active region AC. The plurality of peripheral circuits 120 may include a peripheral circuit gate 122 and a source/drain region 124 on a portion of the substrate 110 and on both sides of the peripheral circuit gate 122.

The first interconnect structure 130 may include a plurality of peripheral circuit wiring layers 132 and a plurality of peripheral circuit contacts 134. The first interconnect structure 130 may include a conductive material, such as copper (Cu), aluminum (Al), tungsten (W), silver (Ag), gold (Au), or a combination thereof. The first bonding pad 150 may be on the first interconnect structure 130 and may be electrically connected to the peripheral circuit 120 and/or the substrate 110 through the first interconnect structure 130. The first insulation structure 140 may be on the substrate 110 and surround the peripheral circuit 120, the first interconnect structure 130, and the first bonding pad 150.

The first bonding pad 150 may include an upper surface that is disposed on the same plane as the upper surface of the first insulation structure 140 (i.e., the upper surfaces of the first bonding pad 150 and the first insulation structure 140 extend from the substrate 110 by a same distance).

In embodiments, the first insulation structure 140 may include an insulating material, such as silicon oxide, silicon nitride, a low-k dielectric material, or a combination thereof. The low-k dielectric material may be a material having a dielectric constant that is less than that of silicon oxide and for example, may include phosphosilicate glass (PSG), boro-phospho-silicate glass (BPSG), fluoride silicate glass (FSG), organosilicate glass (OSG), spin on glass (SOG), spin on polymer, or a combination thereof. In some embodiments, the first insulation structure 140 may include an ultra-low-k (ULK) layer having an ultra-low dielectric constant K of about 2.2 to about 2.4. The ULK layer may include SiOC or SiCOH. The first bonding pad 150 may include a conductive material including Cu, Au, Ag, Al, W, titanium (Ti), tantalum (Ta), or a combination thereof.

The cell array structure CS may include a base insulation layer 202, a common source line layer 210 under the base insulation layer 202, a cell stack 220 under the common source line layer 210, a second interconnect structure 240 electrically connected to the cell stack 220, a second bonding pad 260 electrically connected to the second interconnect structure 240, and a second insulation structure 250 under the cell stack 220 and surrounding the second interconnect structure 240 and the second bonding pad 260. The second bonding pad 260 may include a lower surface that is disposed on the same plane as the lower surface of the second insulation structure 250 (i.e., the lower surfaces of the second bonding pad 260 and the second insulation structure 250 extend from the substrate 110 by a same distance). The base insulation layer 202 may include an insulating material, such as oxide.

FIG. 6Aillustrates the second interconnect structure 240 corresponding to only a plurality of contacts, but the present disclosure is not limited thereto. For example, and like the first interconnect structure 130 including the plurality of peripheral circuit wiring layers 132 and the plurality of peripheral circuit contacts 134, the second interconnect structure 240 may include a plurality of wiring layers and a plurality of contacts. Each of the second interconnect structure 240 and the second insulation structure 250 may include a material that is the same as or similar to that of each of the first interconnect structure 130 and the first insulation structure 140, respectively.

The second insulation structure 250 may contact the first insulation structure 140 and the second bonding pad 260 may contact the first bonding pad 150 corresponding thereto, and thus, the cell array structure CS may be bonded to the peripheral circuit structure PS. For example, the peripheral circuit structure PS and the cell array structure CS may be bonded to each other by a metal-oxide hybrid bonding process, and thus, the second interconnect structure 240 included in the cell array structure CS may be electrically connected to the peripheral circuit 120 included in the peripheral circuit structure PS.

The cell stack 220 may include a plurality of gate electrodes 222 and a plurality of insulation layers 224, which are alternately arranged on the common source line layer 210. The plurality of gate electrodes 222 may include W, Cu, Ag, Au, Al, or a combination thereof, but are not limited thereto and may include a conductive material. The plurality of insulation layers 224 may include an insulating material including silicon oxide, a low-k dielectric material, or a combination thereof.

A buffer insulation layer 212 may be between the common source line layer 210 and the cell stack 220. For example, the buffer insulation layer 212 may be between the common source line layer 210 and a gate electrode 222 as the uppermost layer of the cell stack 220. The buffer insulation layer 212 may include an insulating material, such as oxide. The buffer insulation layer 212 may have a thickness of tens of nanometers (nm) to hundreds of nm. The thickness of the gate electrode 222 may have a value which is greater than or equal to the thickness of the insulation layer 224. For example, the gate electrode 222 may have a thickness of about 10 nm to about 20 nm and the insulation layer 224 may have a thickness of about 10 nm to about 15 nm.

A plurality of cell channel structures 230, which extend through the cell stack 220 in a vertical direction, may be disposed in the cell region CELL. A memory cell string (MS of FIG. 3) including a plurality of memory cells may be on each of the plurality of cell channel structures 230. Each of the plurality of cell channel structures 230 may extend through the cell stack 220 and the buffer insulation layer 212 and may extend in the vertical direction (Z direction) into the base insulation layer 202. For example, a portion of an upper portion of each of the plurality of cell channel structures 230 may extend in the vertical direction (the Z direction) from the upper surface of the buffer insulation layer 212 and may be disposed in the base insulation layer 202.

The common source line layer 210 may be configured to operate as a source region that supplies a current to memory cells provided in the cell array structure CS. The common source line layer 210 may correspond to the common source line CSL illustrated in FIG. 3. The common source line layer 210 may include, for example, a semiconductor material such as Group IV semiconductor materials, Group III-V semiconductor materials, or Group II-VI semiconductor materials. For example, the common source line layer 210 may include at least one material of Si, Ge, SiGe, GaAs, InGaAs, aluminum gallium arsenide (AlGaAs), or a combination thereof. Also, the common source line layer 210 may include a semiconductor doped with n-type impurities. Furthermore, the common source line layer 210 may have a crystalline structure including at least one material selected from among a single crystalline material, an amorphous material, and a polycrystalline material. In some embodiments, the common source line layer 210 may include a semiconductor material that does not include carbon. For example, the common source line layer 210 may include polysilicon. In some embodiments, the common source line layer 210 may include polysilicon that does not include carbon. In some embodiments, the common source line layer 210 may include polysilicon doped with n-type impurities.

The common source line layer 210 may arranged such that the cell channel structure 230 extends into the plurality of gate electrodes 222 and the plurality of insulation layers 224 and contacts the common source line layer 210. The common source line layer 210 may extend along the lower surface of the base insulation layer 202 and may surround a portion of an upper portion of each of the plurality of cell channel structures 230 extending into the base insulation layer 202. The base insulation layer 202 may include a plurality of grooves that correspond to a portion of the upper portion of each of the plurality of cell channel structures 230 extending into the base insulation layer 202 and extend from the lower surface of the base insulation layer 202 into the base insulation layer 202, and the common source line layer 210 may cover or overlap the lower surface of the base insulation layer 202 and the inner surface of each of the plurality of grooves. In some embodiments, the common source line layer 210 may conformally cover or overlap the lower surface of the base insulation layer 202 and the inner surface of each of the plurality of grooves. The common source line layer 210 may extend between the base insulation layer 202 and the buffer insulation layer 212 and between the base insulation layer 202 and the plurality of cell channel structures 230. The common source line layer 210 may cover or overlap the upper surface of the buffer insulation layer 212 and the upper portion of each of the plurality of cell channel structures 230 extending from the upper surface of the buffer insulation layer 212.

In embodiments, the plurality of gate electrodes 222 may correspond to at least one ground selection line GSL, word lines WL1, WL2, ..., WLn-1, and WLn (WL), and at least one string selection line SSL, which configure the memory cell string MS illustrated in FIG. 3. For example, a gate electrode 222 that is closest to the common source line layer 210 may correspond to the ground selection line GSL, at least two gate electrodes 222 that are furthest away from the common source line layer 210 may correspond to the string selection line SSL, and the other gate electrodes 222 may correspond to the word line WL. Therefore, a memory cell string MS may be provided where the ground selection transistor GST and the string selection transistor SST are serially connected with the memory cell transistors MC1, MC2, ..., MCn-1, and MCn therebetween in FIG. 3.

In embodiments, at least one of the gate electrodes 222 may correspond to a dummy word line. For example, at least one gate electrode 222 that corresponds to an additional dummy word line may be between the common source line layer 210 and a gate electrode 222 that corresponds to the ground selection line GSL. As another example, at least one gate electrode 222 that corresponds to an additional dummy word line may be between a gate electrode 222 that corresponds to the ground selection line GSL and a gate electrode 222 that corresponds to the word line WL. As an additional example, at least one gate electrode 222 that corresponds to an additional dummy word line may be between a gate electrode 222 corresponding to the word line WL and a gate electrode 222 that corresponds to the string selection line SSL.

The plurality of cell channel structures 230 may be spaced apart from one another at a certain interval in a first horizontal direction (X direction), a second horizontal direction (Y direction), and a third horizontal direction (for example, a diagonal direction with respect to the first horizontal direction (the X direction) and the second horizontal direction (the Y direction)). The plurality of cell channel structures 230 may be arranged in a zigzag shape or a staggered shape. Each of the plurality of cell channel structures 230 may include a conductive plug 238. The conductive plug 238 may be on one end of each of the plurality of cell channel structures 230 that is opposite to the common source line layer 210.

The plurality of cell channel structures 230 may be within a plurality of channel holes CHH. The plurality of channel holes CHH may extend through the cell stack 220 and the buffer insulation layer 212 and may extend into the base insulation layer 202. The plurality of channel holes CHH may be based on the plurality of gate electrodes 222 and the plurality of insulation layers 224 of the cell stack 220 and may be based on the common source line layer 210 of the base insulation layer 202.

Each of the plurality of cell channel structures 230 may include a gate insulation layer 232, a channel layer 234, a buried insulation layer 236, and the conductive plug 238. The gate insulation layer 232 and the channel layer 234 may be sequentially arranged on the inner sidewall of the channel hole CHH. For example, the gate insulation layer 232 may conformally cover or overlap the inner sidewall of a portion of a channel hole CHH extending through the buffer insulation layer 212 and the cell stack 220, and the channel layer 234 may conformally cover or overlap the inner sidewall and the upper surface of the channel hole CHH. The channel layer 234 may cover or overlap the inner sidewall and the upper surface of the channel hole CHH extending into the common source line layer 210 to contact the common source line layer 210. The gate insulation layer 232 may not extend into the common source line layer 210. For example, the uppermost end of the gate insulation layer 232 may contact the lower surface of the common source line layer 210. The channel layer 234 may extend into the common source line layer 210 along the inner sidewall of the channel hole CHH extending into the common source line layer 210. For example, the uppermost end of the channel layer 234 may be at a vertical level that is higher than the lower surface of the common source line layer 210 (i.e., the distance between the uppermost end of the channel layer 234 and the substrate 110 is greater than the distance between the lower surface of the common source line layer 210 and the substrate 110). Here, the lower surface of the common source line layer 210 may denote the lower surface of the common source line layer 210 except the inner sidewall and the upper surface of a portion of a channel hole CHH extending into the common source line layer 210.

The buried insulation layer 236 at least partially filling a residual space of the channel hole CHH may be on the channel layer 234. The conductive plug 238 contacting the channel layer 234 and at least partially filling an inlet of the channel hole CHH may be under the channel hole CHH. In some embodiments, the buried insulation layer 236 may be omitted, and the channel layer 234 may be formed in a pillar shape which at least fills a residual portion of the channel hole CHH.

The gate electrode 222 may include a metal, such as tungsten, nickel, cobalt, or tantalum, a conductive metal nitride, such as titanium nitride, tantalum nitride, or tungsten nitride, a metal silicide, such as tungsten silicide, nickel silicide, cobalt silicide, or tantalum silicide, doped polysilicon, or a combination thereof. In some embodiments, a dielectric liner may be between the gate electrode 222 and the insulation layer 224, and the dielectric liner may include a high-k dielectric material, such as aluminum oxide.

The gate insulation layer 232 may have a structure including a tunneling dielectric layer 232A, a charge storage layer 232B, and a blocking dielectric layer 232C, which are sequentially stacked on the outer sidewall of the channel layer 234. The relative thickness of each of the tunneling dielectric layer 232A, the charge storage layer 232B, and the blocking dielectric layer 232C is not limited to the illustration of FIG. 6B and may be varied in other embodiments.

The tunneling dielectric layer 232A may include silicon oxide, hafnium oxide, aluminum oxide, zirconium oxide, or tantalum oxide. The charge storage layer 232B may be a region configured to store electrons passing through the tunneling dielectric layer 232A from the channel layer 234 and may include silicon nitride, boron nitride, silicon boron nitride, or impurity-doped polysilicon. The blocking dielectric layer 232C may include silicon oxide, silicon nitride, or metal oxide having permittivity which is greater than that of silicon oxide. The metal oxide may include hafnium oxide, aluminum oxide, zirconium oxide, tantalum oxide, or a combination thereof.

The bit lines BL may extend apart from one another in a second horizontal direction (Y direction) and may be electrically connected with the cell channel structure 230 by a bit line contact BLC. The bit line contact BLC may be connected to the conductive plug 238.

Each of the plurality of gate electrodes 222 may include the pad portion PAD in the connection region EXT. In some embodiments, in the connection region EXT, the plurality of gate electrodes 222 may extend to have a length which is reduced progressively in the first horizontal direction (the X direction) as a distance between the substrate 110 and the common source line layer 210 decreases. In some other embodiments, in the connection region EXT, the plurality of gate electrodes 222 may extend to have a length which is reduced progressively in the first horizontal direction (the X direction) and the second horizontal direction (the Y direction) as a distance between the substrate 110 and the common source line layer 210 decreases. The pad portion PAD may be referred to as portions of the gate electrode 222 arranged in a nonlinear shape (e.g., a staircase shape). In some embodiments, the pad portion PAD may have a staircase shape in the first horizontal direction (the X direction). In other embodiments, the pad portion PAD may have a staircase shape in each of the first horizontal direction (the X direction) and the second horizontal direction (the Y direction). In some embodiments, at least a portion the pad portion PAD may have a thickness that is greater than remaining portions of the plurality of gate electrodes 222 in the cell region CELL.

A plurality of dummy channel structures 230D, which extend through the plurality of gate electrodes 222, the plurality of insulation layers 224, and the buffer insulation layer 212 and extend into the base insulation layer 202 in the vertical direction (the Z direction), may be formed in the connection region EXT. In FIG. 6A, the dummy channel structure 230D is illustrated as being in only the connection region EXT but is not limited thereto. In some embodiments, some of the plurality of dummy channel structures 230D may also be in a portion of the cell region CELL adj acent to the connection region EXT. The dummy channel structures 230D may be on the periphery of each of the plurality of gate contact plugs 270 in the connection region EXT. For example, three or more dummy channel structures 230D may be arranged to surround one gate contact plug 270 along the periphery thereof in at least a three-angled polygonal structure.

The plurality of dummy channel structures 230D may be in the plurality of dummy channel holes DCH in the connection region EXT and/or the cell region CELL. A plurality of dummy channel holes DCH may extend through the cell stack 220 and the buffer insulation layer 212 and may extend into the base insulation layer 202. In some embodiments, the common source line layer 210 may be between the base insulation layer 202 and a portion of an upper portion of each of the plurality of dummy channel structures 230D extending into the base insulation layer 202. The dummy channel structure 230D may prevent or inhibit the leaning or bending of the gate electrode 222 and thus secures the structural stability during a manufacturing process of the non-volatile memory device 100. In some embodiments, the dummy channel structure 230D may have a structure and a shape that are almost the same as or similar to those of the cell channel structure 230. In some other embodiments, the cell channel structure 230 and the dummy channel structure 230D may have different structures and shapes.

A charge insulation layer 228, which covers or overlaps the pad portion PAD and surrounds the plurality of gate contact plugs 270, may be in the connection region EXT. The charge insulation layer 228 may also be in the peripheral connection region PA. The second insulation structure 250 may cover or overlap the cell stack 220 and the charge insulation layer 228. In some embodiments, the second insulation structure 250 may include a plurality of insulation layers, and each of the plurality of insulation layers may overlap or cover the bit line contact BLC, the bit line BL, and the second interconnect structure 240.

The plurality of gate contact plugs 270, which extend through the charge insulation layer 228 and are connected to the pad portions PAD of the plurality of gate electrodes 222, may be in the connection region EXT. The bit line contact BLC and the bit line BL connected to the bit line contact BLC may be under each of the plurality of gate contact plugs 270, and the bit line BL may be connected to the second interconnect structure 240. An insulation spacer 280S may be between a gate electrode 222 and a gate contact plug 270, which are not electrically connected to each other, among the plurality of gate electrodes 222 and the plurality of gate contact plugs 270, respectively.

The plurality of gate contact plugs 270 may extend through the plurality of gate electrodes 222, the plurality of insulation layers 224, and the buffer insulation layer 212 and may extend into the base insulation layer 202 in the vertical direction (the Z direction). The plurality of gate contact plugs 270 may be in a plurality of contact holes MCH that extend through the plurality of gate electrodes 222, the plurality of insulation layers 224, and the buffer insulation layer 212 and extend into the base insulation layer 202 in the vertical direction (the Z direction). For example, a portion of an upper portion of each of the plurality of gate contact plugs 270 may extend in the vertical direction (the Z direction) from the upper surface of the buffer insulation layer 212 and may be in the base insulation layer 202. In some embodiments, each of the plurality of gate contact plugs 270 may include a first seam 270S that extends into each of the plurality of gate contact plugs 270 toward the upper surface of each of the plurality of gate contact plugs 270 from the lower surface thereof. The first seam 270S may be formed as the gate contact plug 270 and does not completely fill the contact hole MCH during a process of forming the gate contact plug 270 in the contact hole MCH.

The plurality of gate contact plugs 270 may not contact and may be spaced apart from the common source line layer 210. A first protection structure 210P1 may be between the base insulation layer 202 and an upper portion of each of the plurality of gate contact plugs 270 extending into the base insulation layer 202. The first protection structure 210P1 may extend toward a region between the buffer insulation layer 212 and the base insulation layer 202 from a region between the base insulation layer 202 and an upper portion of each of the plurality of gate contact plugs 270. The first protection structure 210P1 may have a step shape, such as a brimmed hat shape. A portion of the first protection structure 210P1 between the base insulation layer 202 and the buffer insulation layer 212 may be a step portion of the step shape, or a brim portion of a hat shape. A cut insulation layer 204 may be between the first protection structure 210P1 and the common source line layer 210. A portion of the first protection structure 210P1 between the base insulation layer 202 and the buffer insulation layer 212 may be a step portion of the step shape or a brim portion of a hat shape and may contact the cut insulation layer 204. The cut insulation layer 204 may extend through the base insulation layer 202 in the vertical direction (the Z direction) and may extend along a region between the first protection structure 210P1 and the common source line layer 210. In some embodiments, the cut insulation layer 204 may extend through the base insulation layer 202 in the vertical direction (the Z direction), extend along a region between the first protection structure 210P1 and the common source line layer 210, and extend into the buffer insulation layer 212. For example, the lowermost end of the cut insulation layer 204 may be at a vertical level that is lower than or equal to the lower surface of the common source line layer 210 (i.e., a distance between the lowermost end of the cut insulation layer 204 and the substrate 110 is less than a distance between the lower surface of the common source line layer 210 and the substrate 110) and may be at a vertical level that is higher than the upper surface of a gate electrode 222 of the uppermost end in the cell stack 220 (i.e., a distance between the lowermost end of the cut insulation layer 204 and the substrate 110 is greater than a distance between the upper surface of a gate electrode 222 of the uppermost end and the substrate 110). In some embodiments, an additional insulation layer including the same material as that of the base insulation layer 202 may be formed on the base insulation layer 202, and thus, when the base insulation layer 202 includes the additional insulation layer provided as one body, the cut insulation layer 204 may extend through a portion of the base insulation layer 202. The first protection structure 210P1 may include the same material as that of the common source line layer 210. The thickness of the first protection structure 210P1 may be substantially the same as that of the common source line layer 210. The first protection structure 210P1 may be spaced apart from the dummy channel structure 230D surrounding the gate contact plug 270 contacting the first protection structure 210P1 with the cut insulation layer 204 therebetween.

Each of the plurality of gate contact plugs 270 may extend through the pad portion PAD of the gate electrode 222 electrically connected to a corresponding gate contact plug 270 among the plurality of gate electrodes 222. Vertical heights of the plurality of gate contact plugs 270 may be equal to one another (i.e., distances between a given surface of the gate contact plugs 270 and the substrate 110 may be equal).

In some embodiments, a horizontal diameter of each of the plurality of gate contact plugs 270 and the plurality of contact holes MCH may have a value that is greater than or equal to that of a horizontal diameter of each of the plurality of cell channel structures 230 and the plurality of channel holes CHH. In some embodiments, a horizontal diameter of each of the plurality of dummy channel structures 230D and the plurality of dummy channel holes DCH may have a value that is substantially the same as that of a horizontal diameter of each of the plurality of contact holes MCH.

A plurality of through contact plugs IOMC, which extend through the charge insulation layer 228 and are electrically connected to the peripheral circuit 120 through the second interconnect structure 240 and the first interconnect structure 130, may be in the peripheral connection region PA. The bit line contact BLC and the bit line BL connected to the bit line contact BLC may be under each of the plurality of through contact plugs IOMC, and the bit line BL may be connected to the second interconnect structure 240.

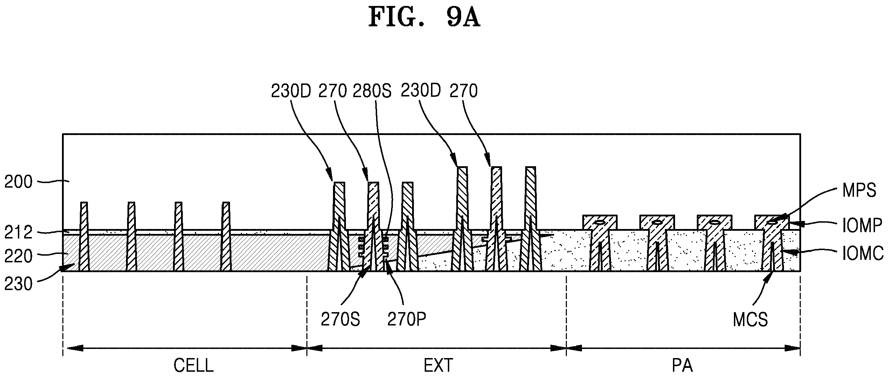

Each of the plurality of through contact plugs IOMC may extend through the charge insulation layer 228 and may be connected to the peripheral connection pad IOMP in the base insulation layer 202. For example, the peripheral connection pad IOMP may extend from the lower surface of the base insulation layer 202 and through the base insulation layer 202. The through contact plug IOMC and the peripheral connection pad IOMP may include a second seam (MCS of FIGS. 9A to 9F) and a third seam (MPS of FIGS. 9A to 9F), that are similar to the first seam 270S included in the gate contact plug 270.

In some embodiments, each of the plurality of cell channel structures 230, the plurality of dummy channel structures 230D, the plurality of gate contact plugs 270, and the plurality of through contact plugs IOMC may have a tapered shape which decreases in horizontal width and extends in the vertical direction (the Z direction) toward the peripheral circuit structure PS from the base insulation layer 202.

In some embodiments, at least some of the plurality of gate contact plugs 270 may extend into the base insulation layer 202 further than the plurality of cell channel structures 230 in the vertical direction (the Z direction) from the cell stack 220. For example, a vertical height of an upper portion of at least some of the plurality of gate contact plugs 270, which is in the base insulation layer 202, may have a value that is greater than that of a vertical height of a portion of an upper portion of each of the plurality of cell channel structures 230.

The plurality of through contact plugs IOMC and the plurality of peripheral connection pads IOMP may not contact and may be spaced apart from the common source line layer 210. A second protection structure 210P2 may be between the base insulation layer 202 and the peripheral connection pad IOMP . The second protection structure 210P2 may extend from a region between the peripheral connection pad IOMP and the base insulation layer 202 to a region between the charge insulation layer 228 and the base insulation layer 202 adjacent to the peripheral connection pad IOMP. The second protection structure 210P2 may have a step shape, such as a brimmed hat shape. A portion of the second protection structure 210P2 between the base insulation layer 202 and the charge insulation layer 228 may be a step portion of the step shape or a brim portion of a hat shape. The cut insulation layer 204 may be between the second protection structure 210P2 and the common source line layer 210. The cut insulation layer 204 may extend through the base insulation layer 202 in the vertical direction (the Z direction) and may extend along a region between the second protection structure 210P2 and the common source line layer 210. In some embodiments, the cut insulation layer 204 may extend through the base insulation layer 202 in the vertical direction (the Z direction), extend along a region between the second protection structure 210P2 and the common source line layer 210, and extend into the charge insulation layer 228. For example, the lowermost end of the cut insulation layer 204 may be at a vertical level that is lower than or equal to the lower surface of the common source line layer 210 (i.e., a distance between the lowermost end of the cut insulation layer 204 and the substrate 110 is less than a distance between the lower surface of the common source line layer 210 and the substrate 110). The second protection structure 210P2 may include the same material as that of the common source line layer 210. A thickness of the second protection structure 210P2 may be substantially the same as that of the common source line layer 210.

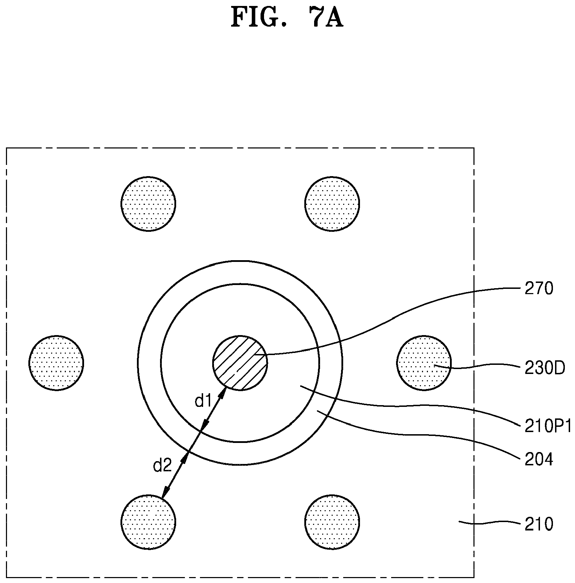

FIGS. 7A to 7E are enlarged plan views of some regions of a non-volatile memory device according to embodiments of the present disclosure. In detail, FIGS. 7A to 7E are enlarged plan views illustrating the arrangement of one gate contact plug 270 and dummy channel structures 230D surrounding the gate contact plug 270 and are plan views taken in a horizontal direction along a common source line layer 210 covering or overlapping a lower surface of a base insulation layer 202 in the connection region EXT illustrated in FIG. 6A.

Referring to FIG. 7A in conjunction with FIGS. 6A and 6D, dummy channel structures 230D may be adjacent to a gate contact plug 270. In some embodiments, one gate contact plug 270 may be surrounded by six dummy channel structures 230D that form a hexagonal structure. A first protection structure 210P1 may contact the gate contact plug 270. In FIG. 7A, a step portion or a brim portion of the first protection structure 210P1 having a step shape or hat shape is illustrated. The brim/step portion of the first protection structure 210P1 may have a circular ring shape that surrounds the gate contact plug 270at a center thereof. For example, the gate contact plug 270 and the first protection structure 210P1 surrounding the gate contact plug 270 may have a circular shape. A cut insulation layer 204 may be between the first protection structure 210P1 and a common source line layer 210 and may insulate the common source line layer 210 from the first protection structure 210P1 and the gate contact plug 270 connected to the first protection structure 210P1. In some embodiments, the cut insulation layer 204 may have a circular ring shape. The cut insulation layer 204 surrounding the gate contact plug 270 may be referred to as a first cut insulation layer.

In some embodiments, a first distance d1 between the gate contact plug 270 and the cut insulation layer 204 and a second distance d2 between the cut insulation layer 204 and the dummy channel structure 230D adjacent to the gate contact plug 270 may have substantially the same value.

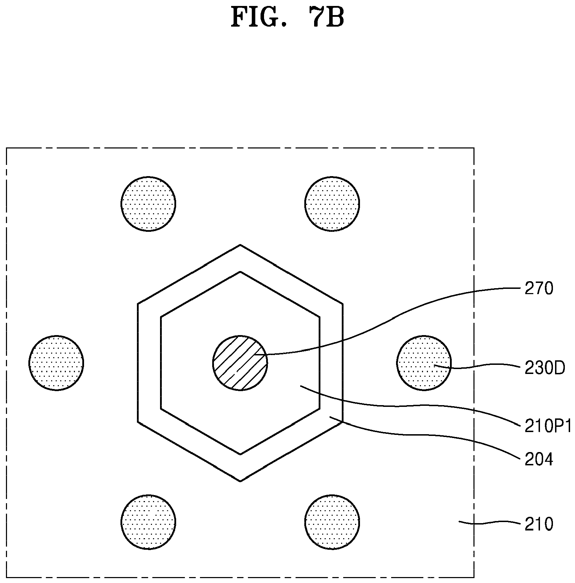

Referring to FIG. 7B in conjunction with FIGS. 6A and 6D, dummy channel structures 230D may be adjacent to a gate contact plug 270. In some embodiments, one gate contact plug 270 may be surrounded by six dummy channel structures 230D that form a hexagonal structure. A first protection structure 210P1 may contact the gate contact plug 270. The gate contact plug 270 and the first protection structure 210P1 surrounding the gate contact plug 270 may have a hexagonal shape. A cut insulation layer 204 may be between the first protection structure 210P1 and a common source line layer 210 and may insulate the common source line layer 210 from the first protection structure 210P1 and the gate contact plug 270 connected to the first protection structure 210P1. In some embodiments, the cut insulation layer 204 may have a hexagonal ring shape. A side of the cut insulation layer 204, which may have a hexagonal ring shape, may be on a virtual line between the gate contact plug 270 and the dummy channel structure 230D.

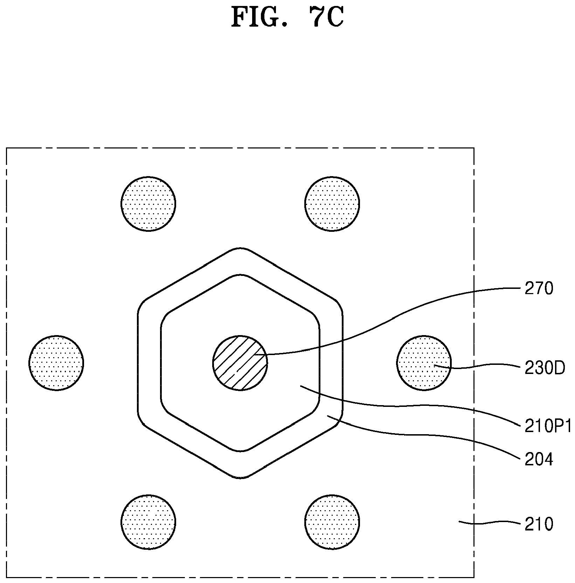

Referring to FIG. 7C in conjunction with FIGS. 6A and 6D, a gate contact plug 270 and a first protection structure 210P1 surrounding the gate contact plug 270 may have a corner-rounded hexagonal shape. A cut insulation layer 204 may be between the first protection structure 210P1 and a common source line layer 210 and may insulate the common source line layer 210 from the first protection structure 210P1 and the gate contact plug 270 connected to the first protection structure 210P1. In some embodiments, the cut insulation layer 204 may have a corner-rounded hexagonal ring shape.

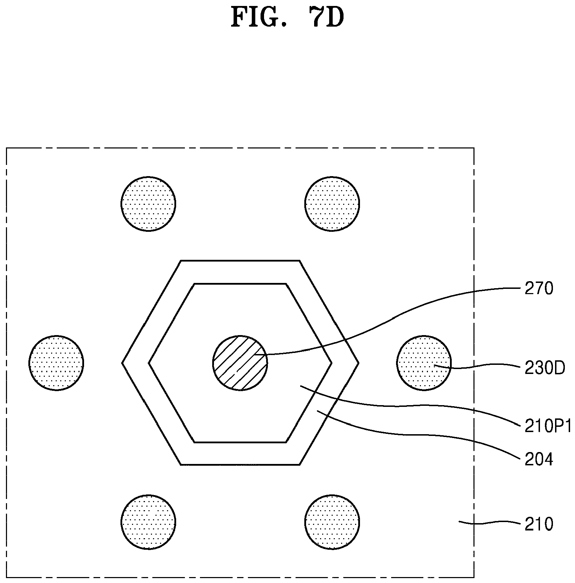

Referring to FIG. 7D in conjunction with FIGS. 6A and 6D, a gate contact plug 270 and a first protection structure 210P1 surrounding the gate contact plug 270 may have a hexagonal shape. In some embodiments, a cut insulation layer 204 may have a hexagonal ring shape. A corner of the cut insulation layer 204, which may have a hexagonal ring shape, may be on a virtual line between the gate contact plug 270 and a dummy channel structure 230D.

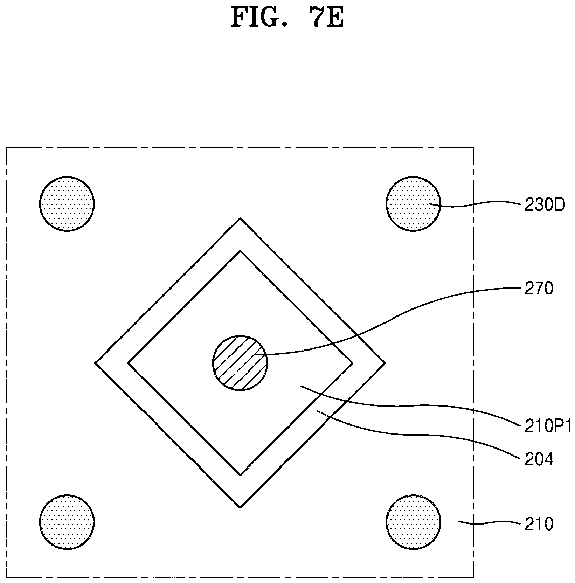

Referring to FIG. 7E in conjunction with FIGS. 6A and 6D, one gate contact plug 270 may be surrounded by four dummy channel structures 230D which are disposed to one-dimensionally have a tetragonal structure. The gate contact plug 270 and a first protection structure 210P1 surrounding the gate contact plug 270 may one-dimensionally have a tetragonal shape. In some embodiments, a cut insulation layer 204 may have a tetragonal ring shape. A side of the cut insulation layer 204 having a tetragonal ring shape may be disposed on a virtual line between the gate contact plug 270 and the dummy channel structure 230D, but the present disclosure is not limited thereto. For example, similarly to the illustration of FIG. 7D, a corner of the cut insulation layer 204 having a tetragonal ring shape may be disposed on the virtual line between the gate contact plug 270 and the dummy channel structure 230D.

FIGS. 7A to 7E illustrate six or four dummy channel structures 230D that surround one gate contact plug 270 and a cut insulation layer 204 that has a circular ring shape, a hexagonal ring shape, or a tetragonal ring shape, but the present disclosure is not limited thereto. For example, the number of dummy channel structures 230D surrounding the one gate contact plug 270 may be 3, 5, or 7 or more, and a plane shape of the cut insulation layer 204 may be a triangular ring shape, a pentagonal ring shape, or a 7 or more-angled ring shape.

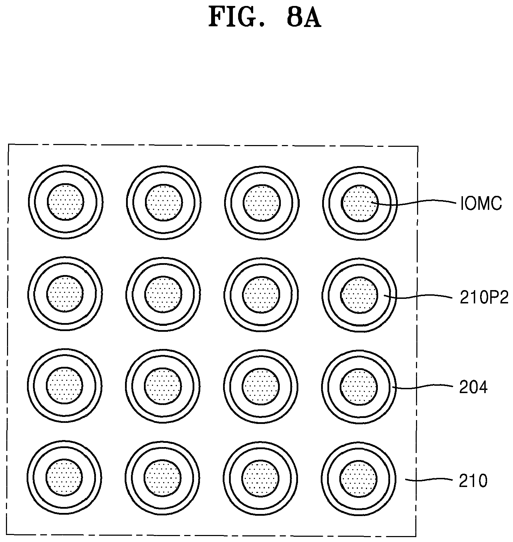

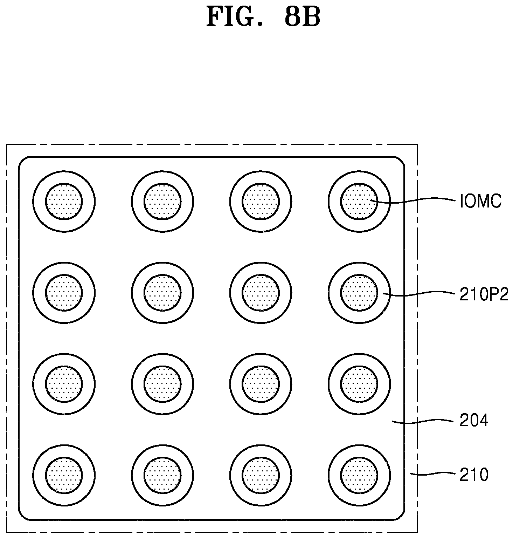

FIGS. 8A and 8B are enlarged plan views of some regions of a non-volatile memory device according to embodiments of the present disclosure. In detail, FIGS. 8A and 8B are enlarged plan views illustrating the arrangement of a plurality of through contact plugs IOMC and are plan views taken in a horizontal direction along a common source line layer 210 covering or overlapping a lower surface of a base insulation layer 202 in the peripheral connection region PA illustrated in FIG. 6A.

Referring to FIG. 8A in conjunction with FIG. 6A, a plurality of through contact plugs IOMC may be spaced apart from one another to form a row and a column in a peripheral connection region PA. The plurality of through contact plugs IOMC may form a lattice pattern or a zigzag shape in one direction, but the present disclosure is not limited thereto. A second protection structure 210P2 may contact each of the plurality of through contact plugs IOMC. In FIG. 8A, a step or brim portion of the second protection structure 210P2 having a step or hat shape is illustrated. The step/brim portion of the second protection structure 210P2 may have a circular ring shape that surrounds the through contact plug IOMC at a center thereof. For example, the through contact plug IOMC and the second protection structure 210P2 surrounding the through contact plug IOMC may have a circular shape. A cut insulation layer 204 may be between the second protection structure 210P2 and a common source line layer 210 and may insulate the common source line layer 210 from the second protection structure 210P2 and the through contact plug IOMC connected to the second protection structure 210P2. In some embodiments, the cut insulation layer 204 may have a circular ring shape. The cut insulation layer 204 surrounding the through contact plug IOMC may be referred to as a second cut insulation layer.

Each of the plurality of through contact plugs IOMC and a plurality of second protection structures 210P2 contacting the plurality of through contact plugs IOMC may be surrounded by another cut insulation layer 204 spaced apart therefrom.

Referring to FIG. 8B in conjunction with FIG. 6A, a cut insulation layer 204 may be between a second protection structure 210P2 and a common source line layer 210 and may insulate the common source line layer 210 from the second protection structure 210P2 and the through contact plug IOMC connected to the second protection structure 210P2. The cut insulation layer 204 may surround the plurality of through contact plugs IOMC and the plurality of second protection structures 210P2 contacting the plurality of through contact plugs IOMC. Each of the plurality of through contact plugs IOMC and the plurality of second protection structures 210P2 contacting the plurality of through contact plugs IOMC may be surrounded by one cut insulation layer 204.

FIGS. 9A to 9F are cross-sectional views illustrating a method of manufacturing a non-volatile memory device according to embodiments of the present disclosure. FIGS. 9A to 9F are cross-sectional views illustrating a method of manufacturing the non-volatile memory device 100 illustrated in FIGS. 6A to 6D, and descriptions that are the same as or similar to the descriptions of FIGS. 6A to 6D may be omitted. In FIGS. 9A to 9F, only the cell array structure CS of the non-volatile memory device 100 illustrated in FIGS. 6A to 6D are illustrated, and some elements of the non-volatile memory device 100 are briefly illustrated while other elements are illustrated in detail.

Referring to FIG. 9A, a buffer insulation layer 212 may be formed on a preliminary substrate 200 including a cell region CELL, a connection region EXT, and a peripheral connection region PA, and a cell stack 220 may be formed on a buffer insulation layer 212 of the connection region EXT and the cell region CELL. Subsequently, a plurality of cell channel structures 230 may be formed in the cell region CELL, a plurality of dummy channel structures 230D and a plurality of gate contact plugs 270 may be formed in the connection region EXT, and a plurality of through contact plugs IOMC and a plurality of peripheral connection pads IOMP may be formed in the peripheral connection region PA. In some embodiments, each of the plurality of gate contact plugs 270 may include a first seam 270S, each of the plurality of through contact plugs IOMC may have a second seam MCS, and each of the plurality of peripheral connection pads IOMP may be formed to include a third seam MPS. Subsequently, a resultant material where the plurality of cell channel structures 230, the plurality of dummy channel structures 230D, the plurality of gate contact plugs 270, the plurality of through contact plugs IOMC, and the plurality of peripheral connection pads IOMP may be vertically reversed on the preliminary substrate 200, and thus, the preliminary substrate 200 may face in an upward direction.

An insulation spacer 280S may be between a gate electrode 222 and a gate contact plug 270, which are not electrically connected to each other, among a plurality of gate electrodes 222 (FIG. 6A) and the plurality of gate contact plugs 270. Each of the plurality of gate contact plugs 270 may include a plug protrusion portion 270P that extends in a horizontal direction toward a gate electrode 222, which is not electrically connected to a corresponding gate contact plug 270. The plug protrusion portion 270P may contact a pad portion (PAD of FIG. 6A) of the gate electrode 222 and may electrically connect the gate contact plug 270 to the gate electrode 222.

In some embodiments, some of the plurality of gate contact plugs 270 may differ in extension length from the cell stack 220 and towards the preliminary substrate 200. For example, a gate contact plug 270 relatively further away from the cell region CELL may be longer in extension length than a gate contact plug 270 relatively closer to the cell region CELL. The number of gate electrodes 222 through which the gate contact plug 270 relatively further away from the cell region CELL extends may be less than the number of gate electrodes 222 through which the gate contact plug 270 relatively closer to the cell region CELL extends.

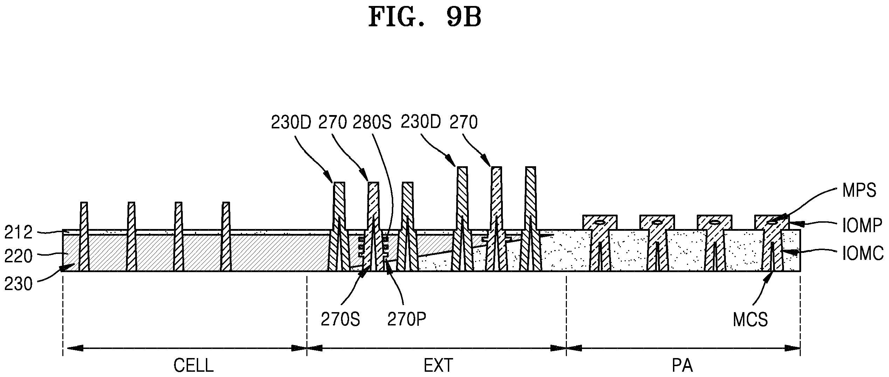

Referring to FIGS. 9A and 9B, an upper portion of each of the plurality of cell channel structures 230, the plurality of dummy channel structures 230D, and the plurality of gate contact plugs 270 and the plurality of peripheral connection pads IOMP may be exposed by removing the preliminary substrate 200.

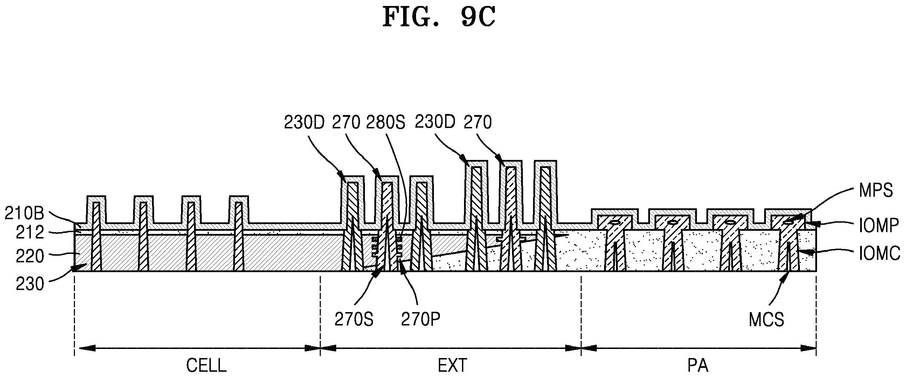

Referring to FIG. 9C, a preliminary common source line layer 210B covering or overlapping a portion of an upper portion of each of the plurality of cell channel structures 230, the plurality of dummy channel structures 230D, and the plurality of gate contact plugs 270 and the plurality of peripheral connection pads IOMP may be formed on the buffer insulation layer 212. The preliminary common source line layer 210B may be formed to conformally cover/overlap a surface of a portion of the upper portion of each of the plurality of cell channel structures 230, the plurality of dummy channel structures 230D, and the plurality of gate contact plugs 270, an upper surface of each of the plurality of peripheral connection pads IOMP, and the upper surface of the buffer insulation layer 212.

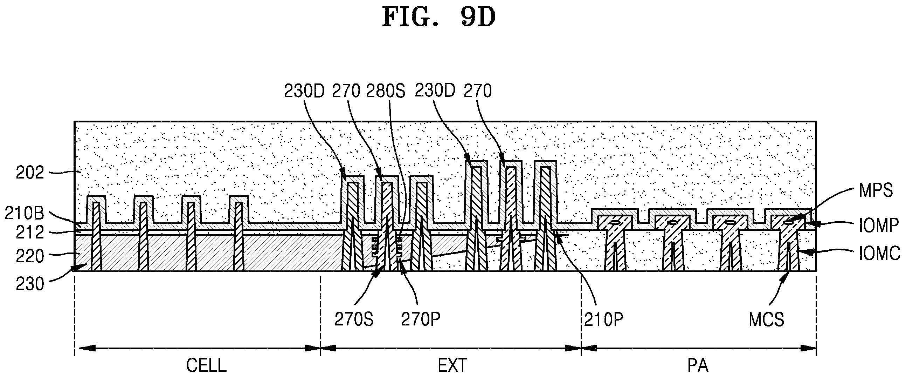

Referring to FIG. 9D, a base insulation layer 202 covering/overlapping the preliminary common source line layer 210B may be formed. The base insulation layer 202 may be formed to have a sufficient thickness and to include an upper surface which has a vertical level that is higher than an uppermost end of the preliminary common source line layer 210B covering/overlapping the plurality of cell channel structures 230, the plurality of dummy channel structures 230D, the plurality of gate contact plugs 270, and the plurality of peripheral connection pads IOMP.

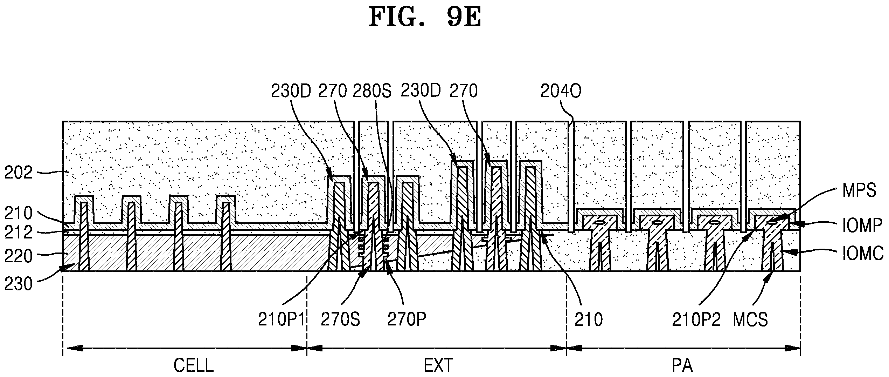

Referring to FIGS. 9D and 9E, a plurality of cut openings 2040 extending through the base insulation layer 202 and the preliminary common source line layer 210B may be formed. A first protection structure 210P1, which is a portion of the preliminary common source line layer 210B covering/overlapping a surface of a portion of an upper portion of each of the plurality of gate contact plugs 270, and a second protection structure 210P2, which is a portion of the preliminary common source line layer 210B covering/overlapping a surface of each of the plurality of peripheral connection pads IOMP, may be separated from, by the plurality of cut openings 2040, the common source line layer 210, which is the other portion of the preliminary common source line layer 210B.

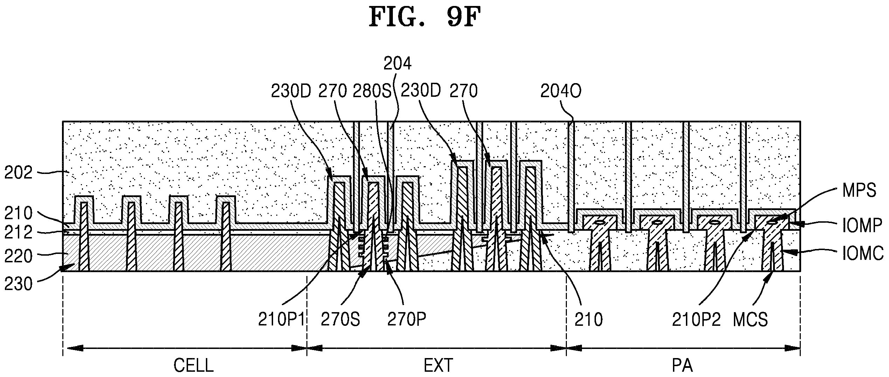

Referring to FIG. 9F, a cut insulation layer 204 at least partially filling the plurality of cut openings 2040 may be formed. The cut insulation layer 204 may be between the first protection structure 210P1 and the common source line layer 210 to electrically insulate the common source line layer 210 from the first protection structure 210P1. The cut insulation layer 204 contacting the second protection structure 210P2 may be between the second protection structure 210P2 and the common source line layer 210 to electrically insulate the common source line layer 210 from the second protection structure 210P2, the peripheral connection pad IOMP contacting the second protection structure 210P2, and the through contact plug IOMC electrically connected to the peripheral connection pad IOMP. The cut insulation layer 204 contacting the gate contact plug 270 may be referred to as a first cut insulation layer, and the cut insulation layer 204 contacting the through contact plug IOMC may be referred to as a second cut insulation layer.

Subsequently, a resultant material of FIG. 9F may be bonded to the peripheral circuit structure PS illustrated in FIG. 6A to form the non-volatile memory device 100 illustrated in FIG. 6A.

Referring to FIGS. 9A to 9F in conjunction with FIGS. 6A to 6D, a non-volatile memory device 100 according to an embodiment may include a ring-shaped cut insulation layer 204 that isolates the common source line layer 210 from the gate contact plug 270 and the peripheral connection pad IOMP connected with the through contact plug IOMC.

The ring-shaped cut insulation layer 204 may isolate the preliminary common source line layer 210B from the common source line layer 210, the first protection structure 210P1, and the second protection structure 210P2, and in a process of forming a plurality of cut insulation layers 204, the gate contact plug 270 and the peripheral connection pad IOMP connected to the through contact plug IOMC may be surrounded by the preliminary common source line layer 210B corresponding to the second protection structure 210P2 and the first protection structure 210P1.

A first seam 270S, a second seam MCS, and a third seam MPS each included in the gate contact plug 270, the through contact plug IOMC, and the peripheral connection pad IOMP may not be exposed in a process of forming the ring-shaped cut insulation layer 204 that isolates the common source line layer 210 from the gate contact plug 270 and the peripheral connection pad IOMP connected to the through contact plug IOMC. Therefore, the occurrence of damage in the gate contact plug 270 and the peripheral connection pad IOMP connected to the through contact plug IOMC may be prevented or inhibited, and thus, the electrical reliability of the non-volatile memory device 100 may be enhanced.

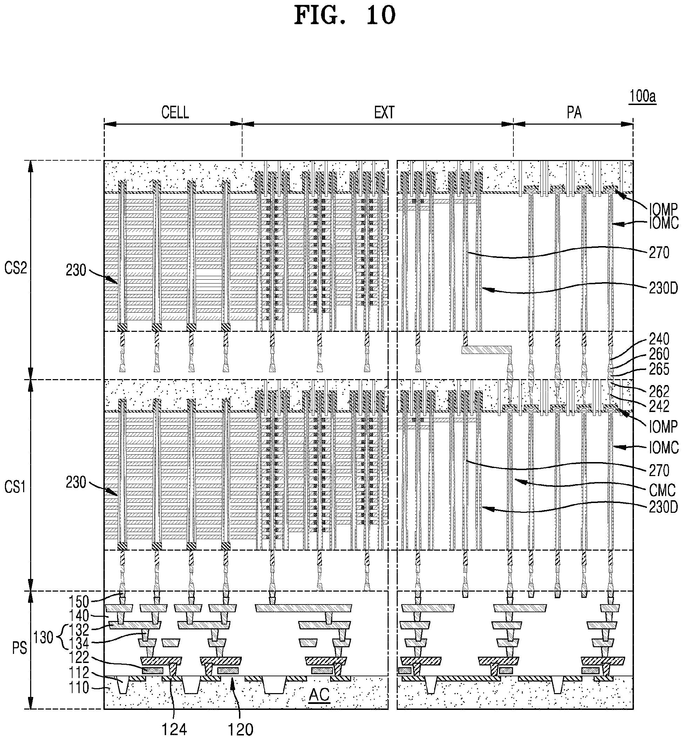

FIG. 10 is a cross-sectional view of a non-volatile memory device having a C2C structure according to embodiments of the present disclosure.

Referring to FIG. 10, a non-volatile memory device 100a may include a peripheral circuit structure PS, a first cell array structure CS1, and a second cell array structure CS2, which are bonded to one another in a vertical direction (Z direction). The first cell array structure CS1 and the second cell array structure CS2 may be substantially the same as the cell array structure CS illustrated in FIGS. 6A to 6D, and thus, repeated descriptions thereof are omitted. For example, the peripheral circuit structure PS and the first cell array structure CS1 may be bonded to each other by a metal-oxide hybrid bonding process, and the first cell array structure CS1 and the second cell array structure CS2 may be bonded to each other by the metal-oxide hybrid bonding process. In some embodiments, the first cell array structure CS1 may further include an upper bonding pad 262, and the second cell array structure CS2 may further include a lower bonding pad 265. For example, the upper bonding pad 262 and the lower bonding pad 265 may contact each other, and thus, the first cell array structure CS1 and the second cell array structure CS2 may be bonded to each other. In some embodiments, the first cell array structure CS1 may further include a third interconnect structure 242 which connects the upper bonding pad 262 to the peripheral connection pad IOMP.

A plurality of gate contact plugs 270 of the second cell array structure CS2 may be electrically connected to the peripheral circuit structure PS through a connection contact plug CMC that is provided in the first cell array structure CS1. In some embodiments, the connection contact plug CMC may be in a peripheral connection region PA of the first cell array structure CS1. The connection contact plug CMC may be substantially the same as the through contact plug IOMC.

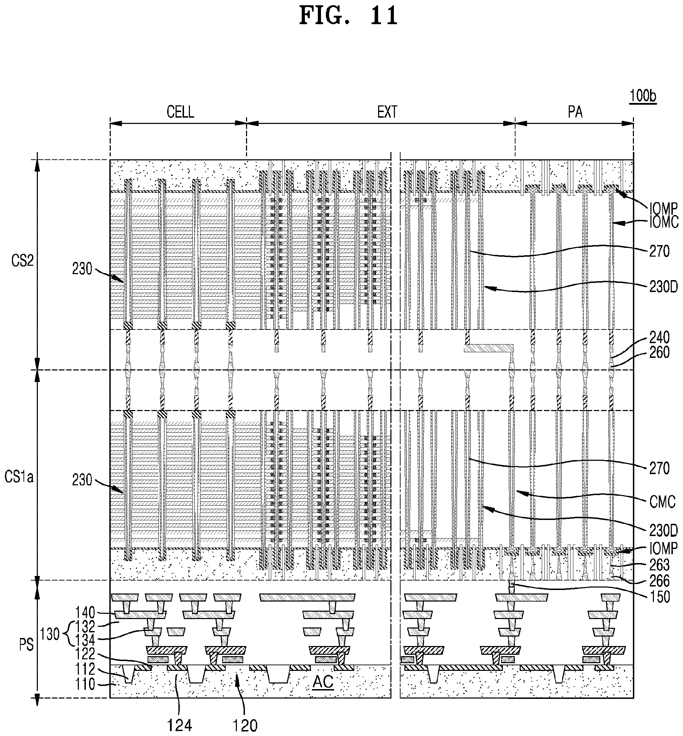

FIG. 11 is a cross-sectional view of a non-volatile memory device having a C2C structure, according to embodiments of the present disclosure.

Referring to FIG. 11, a non-volatile memory device 100b may include a peripheral circuit structure PS, a first cell array structure CS1a, and a second cell array structure CS2, which are bonded to one another in a vertical direction (Z direction). The first cell array structure CS1a and the second cell array structure CS2 may be substantially the same as the cell array structure CS illustrated in FIGS. 6A to 6D, and thus, repeated descriptions thereof are omitted.

The first cell array structure CS1a and the second cell array structure CS2 may have a vertical symmetric structure in a vertical direction. For example, the first cell array structure CS1a may have a structure where the first cell array structure CS1 of FIG. 10 is vertically reversed.

For example, the peripheral circuit structure PS and the first cell array structure CS1a may be bonded to each other by the metal-oxide hybrid bonding process, and the first cell array structure CS1a and the second cell array structure CS2 may be bonded to each other by the metal-oxide hybrid bonding process. In some embodiments, the first cell array structure CS1a may further include a lower bonding pad 266, and as the lower bonding pad 266 and a first bonding pad 150 contact each other, the peripheral circuit structure PS and the first cell array structure CS1a may be bonded to each other. Second bonding pads 260 of each of the first cell array structure CS1a and the second cell array structure CS2 may contact each other, and thus, the first cell array structure CS1a and the second cell array structure CS2 may be bonded to each other. In some embodiments, the first cell array structure CS1a may further include a third interconnect structure 263 which connects the lower bonding pad 266 to the peripheral connection pad IOMP.

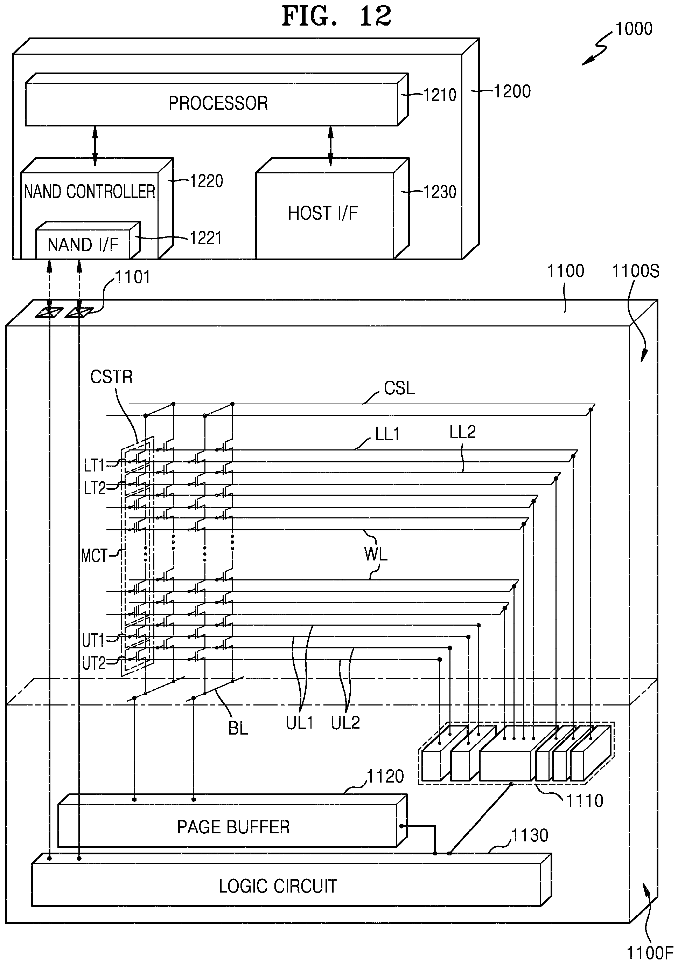

FIG. 12 is a diagram schematically illustrating a memory system 1000 including a non-volatile memory device, according to embodiments of the present disclosure.

Referring to FIG. 12, the memory system 1000 may include one or more memory devices 1100 and a memory controller 1200 electrically connected to the memory devices 1100. The memory system 1000 may include, for example, a solid state drive (SSD) device, a universal serial bus (USB), a computing system, a medical device, or a communication device, which includes the one or more memory devices 1100.

The memory device 1100 may be a non-volatile memory device. For example, the memory device 1100 may be a NAND flash memory device which includes one of the non-volatile memory devices 100, 100a, and 100b described above with reference to FIGS. 5 to 11 or a combination thereof. The memory device 1100 may include a first structure 1100F and a second structure 1 100S on the first structure 1100F. The first structure 1100F may correspond to the peripheral circuit structure PS illustrated in FIGS. 6A, 10, and 11. The peripheral circuit 120 illustrated in FIGS. 6A, 10, and 11 may include a row decoder 1110, a page buffer 1120, and a logic circuit 1130.

The second structure 11005 may correspond to the cell array structure CS illustrated in FIG. 6A, the first cell array structure CS1 and the second cell array structure CS2 illustrated in FIG. 10, or the first cell array structure CS1a and the second cell array structure CS2 illustrated in FIG. 11. The second structure 1100S may include a bit line BL, a common source line CSL, a plurality of word lines WL, first and second string selection lines UL1 and UL2, first and second ground selection lines LL1 and LL2, and a plurality of memory cell strings CSTR between the bit line BL and the common source line CSL. The plurality of cell channel structures 230 and the plurality of gate electrodes 222 illustrated in FIGS. 6A, 10, and 11 may correspond to the plurality of memory cell strings CSTR.

In the second structure 1100S, each of the plurality of memory cell strings CSTR may include ground selection transistors LT1 and LT2 adjacent to the common source line CSL, string selection transistors UT1 and UT2 adjacent to the bit line BL, and a plurality of memory cell transistors MCT between the ground selection transistors LT1 and LT2 and the string selection transistors UT1 and UT2. The number of ground selection transistors LT1 and LT2 and the number of string selection transistors UT1 and UT2 may vary in other embodiments. One of the plurality of gate electrodes 222 and one of the plurality of cell channel structures 230 illustrated in FIGS. 6A, 10, and 11 may correspond to one of the plurality of transistors LT1, LT2, UT1, UT2, and MCT.

In embodiments, the plurality of ground selection lines LL1 and LL2 may be respectively connected to gate electrodes of the ground selection transistors LT1 and LT2. The word line WL may be connected to a gate electrode of the memory cell transistor MCT. The plurality of string selection lines UL1 and UL2 may be respectively connected to gate electrodes of the string selection transistors UT1 and UT2.

The common source line CSL, the plurality of ground selection lines LL1 and LL2, the plurality of word lines WL, and the plurality of string selection lines UL1 and UL2 may be connected to the row decoder 1110. The plurality of bit lines BL may be electrically connected with the page buffer 1120.

The memory device 1100 may communicate with the memory controller 1200 through an external connection pad 1101 electrically connected to the logic circuit 1130. The external connection pad 1101 may be electrically connected to the logic circuit 1130.

The memory controller 1200 may include a processor 1210, a NAND controller 1220, and a host interface 1230. In some embodiments, the memory system 1000 may include a plurality of memory devices 1100, and in this case, the memory controller 1200 may control the plurality of memory devices 1100.

The processor 1210 may control an overall operation of the memory system 1000 including the memory controller 1200. The processor 1210 may operate based on certain firmware and may control the NAND controller 1220 to access the memory device 1100. The NAND controller 1220 may include a NAND interface (I/F) 1221 which processes communication with the memory device 1100. A control command for controlling the memory device 1100, data which is to be written in a plurality of memory cell transistors MCT of the memory device 1100, and data which is to be read from the plurality of memory cell transistors MCT of the memory device 1100 may be transferred through the NAND interface 1221. The host interface 1230 may provide a communication function between the memory system 1000 and an external host. When the control command is received from the external host through the host interface 1230, the processor 1210 may control the memory device 1100 in response to the control command.

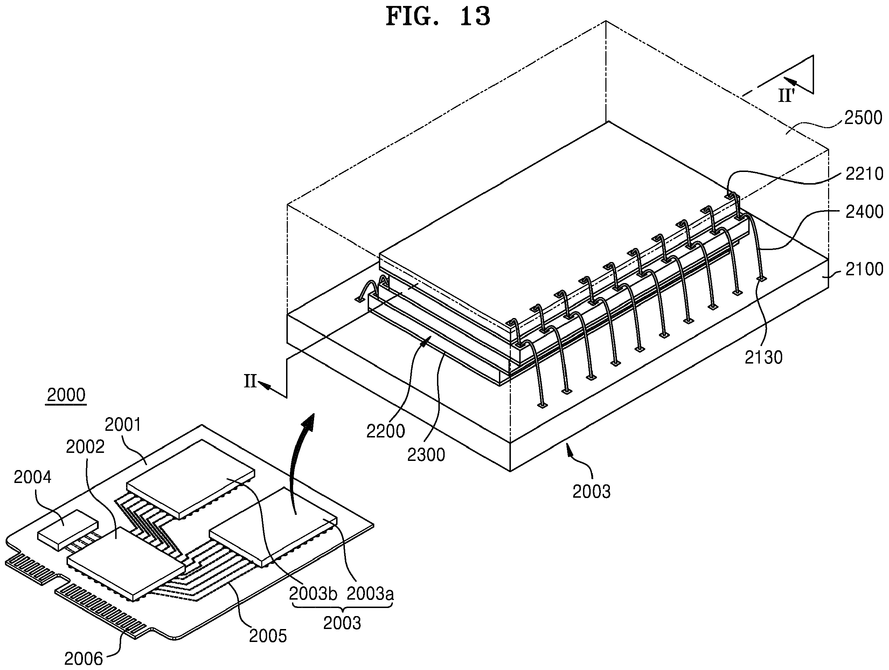

FIG. 13 is a perspective view schematically illustrating a memory system 2000 including a non-volatile memory device according to embodiments of the present disclosure.

Referring to FIG. 13, the memory system 2000 according to embodiments may include a main substrate 2001, a memory controller 2002 mounted on the main substrate 2001, one or more semiconductor packages 2003, and a dynamic random access memory (DRAM) 2004. The semiconductor package 2003 and the DRAM 2004 may be connected to the memory controller 2002 by a plurality of wiring patterns 2005 formed on the main substrate 2001.

The main substrate 2001 may include a connector 2006 including a plurality of pins coupled to the external host. In the connector 2006, the number and arrangement of pins may be modified based on a communication interface between the memory system 2000 and the external host. In embodiments, the memory system 2000 may communicate with the external host based on one of interfaces, such as USB, peripheral component interconnect express (PCI-E), serial advanced technology attachment (SATA), and universal flash storage (UFS) M-Phy. In embodiments, the memory system 2000 may operate with power supplied from the external host through the connector 2006. The memory system 2000 may further include a power management integrated circuit (PMIC) which divides the power supplied from the external host to the memory controller 2002 and the semiconductor package 2003.

The memory controller 2002 may record data in the semiconductor package 2003, or may read data from the semiconductor package 2003 and may improve an operation speed of the memory system 2000.

The DRAM 2004 may be a buffer memory for decreasing a speed difference between the external host and the semiconductor package 2003, which is a data storage space. The DRAM 2004 included in the memory system 2000 may be configured to operate as a cache memory and may provide a space for temporarily storing data in a control operation on the semiconductor package 2003. When the DRAM2004 is included in the memory system 2000, the memory controller 2002 may further include a DRAM controller for controlling the DRAM 2004, in addition to a NAND controller for controlling the semiconductor package 2003.

The semiconductor package 2003 may include first and second semiconductor packages 2003a and 2003b which are spaced apart from each other. Each of the first and second semiconductor packages 2003a and 2003b may be a semiconductor package that includes a plurality of semiconductor chips 2200. Each of the first and second semiconductor packages 2003a and 2003b may include a package substrate 2100, a plurality of semiconductor chips 2200 on the package substrate 2100, an adhesive layer 2300 on a lower surface of each of the plurality of semiconductor chips 2200, a connection structure 2400 electrically connecting the plurality of semiconductor chips 2200 to the package substrate 2100, and a molding layer 2500 which covers/overlaps the plurality of semiconductor chips 2200 and the connection structure 2400 on the package substrate 2100.

The package substrate 2100 may be a printed circuit board (PCB) including a plurality of package upper pads 2130. The plurality of semiconductor chips 2200 may each include an I/O pad 2210. Each of the plurality of semiconductor chips 2200 may include at least one of the non-volatile memory devices described above with reference to FIGS. 5 to 11.

In embodiments, the connection structure 2400 may be a bonding wire which electrically connects the I/O pad 2210 to the package upper pad 2130. Therefore, in the first and second semiconductor packages 2003a and 2003b, the plurality of semiconductor chips 2200 may be electrically connected to one another by a bonding wire scheme and may be electrically connected to the package upper pad 2130 of the package substrate 2100. In embodiments, in the first and second semiconductor packages 2003a and 2003b, the plurality of semiconductor chips 2200 may be electrically connected to one another by a connection structure including a through silicon via (TSV) instead of the connection structure 2400 based on the bonding wire scheme.

In embodiments, the memory controller 2002 and the plurality of semiconductor chips 2200 may be included in one package. In embodiments, the memory controller 2002 and the plurality of semiconductor chips 2200 may be mounted on a separate interposer substrate differing from the main substrate 2001, and the memory controller 2002 and the plurality of semiconductor chips 2200 may be connected to each other by a wiring formed on the interposer substrate.

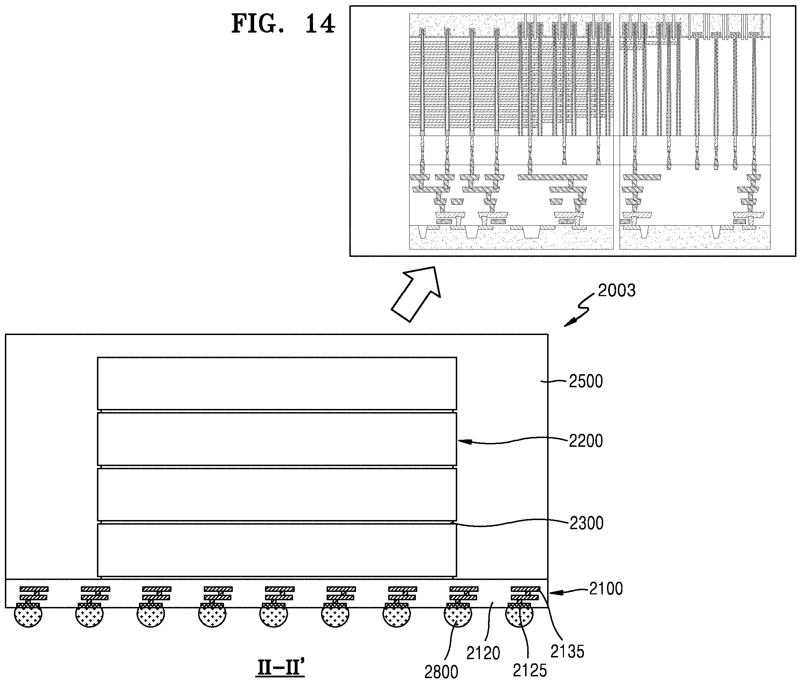

FIG. 14 is a cross-sectional view schematically illustrating a semiconductor package 2003 according to embodiments of the present disclosure.

Referring to FIG. 14, in the semiconductor package 2003, a package substrate 2100 may be a PCB. The package substrate 2100 may include a package substrate body part 2120, a plurality of package upper pads 2130 (see FIG. 13) on an upper surface of the package substrate body part 2120, a plurality of lower pads 2125 disposed on or exposed through a lower surface of the package substrate body part 2120, and a plurality of internal wirings 2135 that electrically connect the plurality of package upper pads 2130 (see FIG. 13) to the plurality of lower pads 2125, in the package substrate body part 2120. As illustrated in FIG. 13, the plurality of package upper pads 2130 may be electrically connected to the plurality of connection structures 2400. The plurality of lower pads 2125 may be connected to, through a plurality of conductive bumps 2800, the plurality of wiring patterns 2005 on the main substrate 2001 of the memory system 2000 illustrated in FIG. 13. Each of the plurality of semiconductor chips 2200 may include at least one of the non-volatile memory devices described above with reference to FIGS. 5 to 11.

Embodiments have been described by using the terms described herein, but this has been merely used for describing the present disclosure and has not been used for limiting a meaning or limiting the scope of the present disclosure defined in the following claims. Therefore, it may be understood by those of ordinary skill in the art that various modifications and other equivalent embodiments may be implemented from the present disclosure.

While the present disclosure has been particularly shown and described with reference to embodiments thereof, it will be understood that various changes in form and details may be made therein without departing from the scope of the following claims.

## Claims

1. A non-volatile memory device comprising:
a peripheral circuit structure comprising a peripheral circuit and a first insulation structure on the peripheral circuit; and
a cell array structure on the peripheral circuit structure, wherein the cell array structure comprises:
a base insulation layer;
a common source line layer on the base insulation layer;
a buffer insulation layer on the common source line layer;
a cell stack on the buffer insulation layer, wherein the cell stack comprises a plurality of gate electrodes and a plurality of insulation layers, and wherein the plurality of gate electrodes have a nonlinear shape;
a plurality of cell channel structures that extend into the cell stack and the buffer insulation layer and that are connected to the common source line layer;
a plurality of gate contact plugs that extend into the cell stack, wherein each gate contact plug of the plurality of gate contact plugs is connected to one corresponding gate electrode of the plurality of gate electrodes;
a plurality of first protection structures between the plurality of gate contact plugs and the base insulation layer;
a plurality of first cut insulation layers that extend into the base insulation layer, wherein the plurality of first cut insulation layers are between the common source line layer and the plurality of first protection structures, and wherein the plurality of first cut insulation layers at least partially surround the plurality of gate contact plugs; and
a second insulation structure on the cell stack and that is connected to the first insulation structure.

2. The non-volatile memory device of claim 1, wherein each gate contact plug of the plurality of gate contact plugs extends through the base insulation layer,
each first protection structure of the plurality of first protection structures at least partially surrounds a portion of one corresponding gate contact plug of the plurality of gate contact plugs, and
the plurality of first protection structures extend between the buffer insulation layer and the base insulation layer that is adjacent to the plurality of gate contact plugs, and wherein each first protection structure of the plurality of first protection structures respectively is connected to one corresponding first cut insulation layer of the plurality of first cut insulation layers.

3. The non-volatile memory device of claim 2, wherein each first protection structure of the plurality of first protection structures comprises a step shape, and
a portion of each first protection structure of the plurality of first protection structures between the base insulation layer and the buffer insulation layer corresponds to a step portion of the step shape.

4. The non-volatile memory device of any one of claims 1 to 3, wherein each of the plurality of first cut insulation layers comprises a ring shape.

5. The non-volatile memory device of any one of claims 1 to 4, wherein the plurality of cell channel structures extend into the cell stack, the buffer insulation layer, and the base insulation layer, and
the common source line layer is on a lower surface of the base insulation layer and inner surfaces of a plurality of grooves that extend from the lower surface of the base insulation layer and into the base insulation layer.

6. The non-volatile memory device of any one of claims 1 to 5, wherein the cell array structure further comprises a plurality of dummy channel structures that extend into the cell stack, wherein the plurality of dummy channel structures and the plurality of first cut insulation layers at least partially surround the plurality of gate contact plugs,
each first cut insulation layer of the plurality of first cut insulation layers is between one corresponding gate contact plug of the plurality of gate contact plugs and one corresponding dummy channel structure of the plurality of dummy channel structures,
each dummy channel structure of the plurality of dummy channel structures extends through the base insulation layer, and
the common source line layer at least partially surrounds a portion of each gate contact plug of the plurality of gate contact plugs that extends through the base insulation layer.

7. The non-volatile memory device of any one of claims 1 to 6, comprising:
a plurality of dummy channel structures that extend into the cell stack and are connected to the common source line layer, wherein each dummy channel structure of the plurality of dummy channel structures at least partially surrounds one corresponding gate contact plug of the plurality of gate contact plugs;
a charge insulation layer on the common source line layer and the cell stack;
a plurality of through contact plugs that extend into the charge insulation layer and are connected to the peripheral circuit;
a plurality of peripheral connection pads that are connected to the plurality of through contact plugs and within the base insulation layer;
a plurality of second protection structures, wherein each second protection structure of the plurality of second protection structures is between one corresponding peripheral connection pad of the plurality of peripheral connection pads and the base insulation layer; and
a second cut insulation layer that extends through at least a portion of the base insulation layer, wherein the second cut insulation layer is between the common source line layer and the plurality of second protection structures to at least partially surround at least one of the plurality of through contact plugs,
wherein the second insulation structure is on the cell stack and the charge insulation layer,
wherein each first protection structure of the plurality of first protection structures is between one corresponding gate contact plug of the plurality of gate contact plugs and the base insulation layer, and
wherein each first cut insulation layer of the plurality of first cut insulation layers is between the common source line layer and one corresponding first protection structure of the plurality of first protection structures to at least partially surround one corresponding gate contact plug of the plurality of gate contact plugs.

8. The non-volatile memory device of claim 7, wherein each of the common source line layer and the plurality of first protection structures comprises a same material and a same thickness.

9. The non-volatile memory device of claim 7 or 8, wherein each first cut insulation layer of the plurality of first cut insulation layers comprises a ring shape and is between one corresponding gate contact plug of the plurality of gate contact plugs and one corresponding dummy channel structure of the plurality of dummy channel structures.

10. The non-volatile memory device of any one of claims 7 to 9, further comprising a plurality of the second cut insulation layers , and
each of the plurality of second cut insulation layers has a ring shape that at least partially surrounds each of the plurality of second protection structures connected to the plurality of peripheral connection pads.

11. The non-volatile memory device of any one of claims 7 to 10, wherein each of the plurality of gate contact plugs extends through the base insulation layer, and
each of the plurality of first protection structures comprises a step shape that surrounds a portion of each of the plurality of gate contact plugs and that extends between the buffer insulation layer and the base insulation layer.

12. The non-volatile memory device of any one of claims 7 to 11, wherein each of the plurality of cell channel structures and each of the plurality of dummy channel structures extend into the cell stack, the buffer insulation layer, and the base insulation layer, and
the common source line layer is on a lower surface of the base insulation layer and inner surfaces of a plurality of grooves that extend from the lower surface of the base insulation layer and into the base insulation layer.

13. The non-volatile memory device of any one of claims 7 to 12, wherein each of the plurality of first cut insulation layers extends through at least a portion of the base insulation layer, extends between the common source line layer and the plurality of first protection structures, and extends through the buffer insulation layer in a vertical direction.

14. A memory system comprising the non-volatile memory device according to any one of claims 1 to 13.

15. The memory system of claim 14, wherein each of the plurality of gate contact plugs extends through the base insulation layer, and
each of the plurality of first protection structures at least partially surrounds a portion of a corresponding gate contact plug of the plurality of gate contact plugs and extends between the buffer insulation layer and the base insulation layer that is adjacent to the plurality of gate contact plugs.
